(19) **Europäisches Patentamt / European Patent Office / Office européen des brevets**

(11) **EP 2 191 513 B1**

(12) **EUROPEAN PATENT SPECIFICATION**

(45) Date of publication and mention
of the grant of the patent:
**23.12.2015 Bulletin 2015/52**

(21) Application number: **08769026.9**

(22) Date of filing: **20.03.2008**

(51) Int Cl.:
*H01L 31/068* (2012.01)   *H01L 31/18* (2006.01)

(86) International application number:
**PCT/US2008/057702**

(87) International publication number:
**WO 2009/032359 (12.03.2009 Gazette 2009/11)**

(54) **GROUP IV NANOPARTICLE JUNCTIONS AND DEVICES THEREFROM**

GRUPPE-IV-NANOPARTIKEL-ÜBERGÄNGE UND EINRICHTUNGEN DARAUS

JONCTIONS DE NANOPARTICULES DE GROUPE IV ET DISPOSITIFS ISSUS DE CELLES-CI

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **04.09.2007 US 969887 P**
**12.02.2008 US 29838**

(43) Date of publication of application:
**02.06.2010 Bulletin 2010/22**

(60) Divisional application:
**12178526.5 / 2 530 725**

(73) Proprietor: **Innovalight, Inc.**
**Sunnyvale, California 94085 (US)**

(72) Inventors:
• **ABBOTT, Malcolm**
  **Sunnyvale, California 94087 (US)**
• **KELMAN, Maxim**
  **Mountain View, California 94043 (US)**
• **LEMMI, Francesco**
  **Sunnyvale, California 94086 (US)**
• **MEISEL, Andreas**
  **Mountain View, CA 94043 (US)**
• **POPLAVSKYY, Dmitry**
  **San Jose, California 95129 (US)**
• **TERRY, Mason**
  **Belmont, CA 94002 (US)**
• **VANHEUSDEN, Karel**
  **Los Altos, California 94024 (US)**

(74) Representative: **de Bresser, Sara Jean et al**
**Dehns**
**St Bride's House**
**10 Salisbury Square**
**London EC4Y 8JD (GB)**

(56) References cited:
**WO-A-2004/055909    WO-A-2004/093202**
**WO-A-2006/063893    DE-A1- 4 235 376**
**US-A1- 2007 175 507**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## CROSS-REFERENCE TO RELATED APPLICATIONS

This application claims the benefit of U.S. Pat. App. No. 12/029,838, filed February 12, 2008, and of U.S. Provisional Pat. App. No. 60/969,887, filed September 4, 2007, entitled *METHODS AND APPARATUS FOR CREATING JUNCTIONS ON A* SUBSTRATE.

## FIELD OF DISCLOSURE

This disclosure relates in general to nanoparticles and in particular to Group IV nanoparticle junctions and devices therefrom.

## BACKGROUND

Semiconductors form the basis of modem electronics. Possessing physical properties that can be selectively modified and controlled between conduction and insulation, semiconductors are essential in most modem electrical devices (*e.g.*, computers, cellular phones, photovoltaic cells, etc.). Group IV semiconductors generally refer to those elements in the fourth column of the periodic table (*e.g.*, carbon, silicon, germanium, etc.).

In general, a solid semiconductor tends to exist in three forms: crystalline, polycrystalline, and amorphous. In crystalline form, semiconductor atoms are positioned in a single unbroken crystal lattice with no grain boundaries. In polycrystalline form, the semiconductor atoms are positioned in many smaller and randomly oriented crystallites (smaller crystals). The crystallites are often referred to as grains. In amorphous form, the semiconductor atoms show no long-range positional order.

Conduction generally refers to the movement of electrically charged carriers, such as electrons or holes (a lack of electrons), through electromagnetic fields. Metals tend to have substantial amounts of electrically charged particles available, whereas insulators have very few.

In the absence of impurities (called dopants), a semiconductor tends to behave as insulator, inhibiting the flow of an electric current. However, after the addition of relatively small amounts of dopants, the electrical characteristics of a semiconductor can dramatically change to a conductor by increasing the amount of electrically charged carriers. For example, in a process called photoexcitation, absorbed light will generally create an electron-hole pair (photocarriers) that in turn tends to increase overall conductivity (photoconductivity).

Depending on the kind of impurity, a doped region of a semiconductor can have more electrons (n-type) or more holes (p-type). For example, in a common configuration, a p-type region is placed next to an n-type (counter doped) region in order to create a (p-n) junction with a "built-in" potential. That is, the energy difference between the two Fermi levels.

Under generally accepted principals of quantum mechanics, electrons of an atom can only reside in certain states, so that only particular energy levels are possible. However, the occupation of particular energy states cannot be determined with particularity. Consequently, for an assemble of atoms (*e.g.*, solid) a probability distribution or density is commonly used, called the Fermi level. In general, the Fermi level describes the energy level at given temperature in which ½ of the energy states are filled. Energy states are unique and correspond to a quantum number.

Consequently, electrons on the p-type side of the junction within the electric field may then be attracted to the n-type region and repelled from the p-type region, whereas holes within the electric field on the n-type side of the junction may then be attracted to the p-type region and repelled from the n-type region. Generally, the n-type region and/or the p-type region can each respectively be comprised of varying levels of relative dopant concentration, often shown as n-, n+, n++, p-, p+, p++, etc.. The built-in potential and thus magnitude of electric field generally depend on the level of doping between two adjacent layers.

In another typical configuration, a junction may be created by placing an intrinsic (undoped) semiconductor layer (i-type) between the n-type region and the p-type region in order to mitigate the effects of quantum tunneling, a quantum-mechanical effect in which an electron transitions through a classically-forbidden energy state. In general, in a depletion region, the generated electromagnetic field is the result of the built-in potential and the applied reverse bias, divided by the depletion width. However, built-in potential is also inversely proportional to the defect density of the depletion region. Consequently, for materials having high defect density (*i.e.,* undesirable energy states) tunneling may occur.

Thus, an i-type region with a lower defect density may be used to minimize tunneling. That is, lower the defect density. For example, without an intrinsic separation layer, if the p-n junction is sufficiently narrow, a high electromagnetic field may generate a tunneling current in the same direction as the electromagnetic field. That is, tunneling electrons may travel directly from the valence band of the p-type region into the conduction band of the n-type region. In contrast, if the p-n junction was ideal, there would be no current because there are no carriers for the electromagnetic field to draw.

In yet another typical configuration, a metal junction may be created by placing a heavily doped n-type region (n++) or a p-type region (p++) next to a metal region in order to form an ohmic (low-resistance) contact. In general, placing a doped region next to a metal creates a potential barrier at the junction. However, increasing the dopant concentration also tends to narrow the depletion region, which in turn tends to create a higher electromagnetic field, and thus a higher quantum tunneling probability. In addition, increasing the dopant concentration also tends to increase the probability that at least some of the charge carriers (electrons or holes) have enough thermal energy to jump over the potential barrier and cross into the metal region to become current.

There are several methods of doping a semiconductor. However, most of these may be problematic. For example, a common method involves depositing a doped glass on a semiconductor substrate via a silk-screen. A printing technique that makes use of a squeegee, silk-screening mechanically forces a liquid, such as a highly doped glass paste, directly onto a substrate. Once exposed to relatively high temperature (*e.g.*, 800-1100°C), the dopants tend to diffuse from the highly-doped glass into the substrate. The high temperature will also tend to anneal the substrate.

Annealing is generally the process of heating a material above a certain critical temperature in order to reduce the materials internal stresses, and or improve its physical and electrical properties. In the case of a semiconductor substrate, annealing allows the dopant atoms to properly diffuse (from a high to a lower concentration region) and position themselves in the lattice, such that the additional electrons or holes (which tend to donate electrons or holes respectively) are available for the transmission of current. This is generally called activation (or effectiveness of "donation") and is critical for the creation of an efficient junction.

However, the downward mechanical force of the squeegee also tends to subject the substrate to stress, and hence may detrimentally affect the electrical and physical characteristics of the substrate. For devices that required multiple deposition steps, such as a back contact solar cell, the stress is aggravated. In general, every additional screen printing step tends to reduce the process yield (and increase costs) due to damage or breakage. Additionally, alignment of the screen pattern may also present substantial challenges. For example, if pattern alignment is poor, the resulting solar cells may malfunction (short) further reducing process yield.

In an alternate doping method, dopants may be deposited in a crystalline or polycrystalline substrate through ion implantation. Ion implantation generally accelerates dopant ions into the substrate at high energy. Like diffusion doping, the substrate must also generally be annealed at a high temperature to repair the substrate and activate the dopants. However, although dopant dosage may be controlled with high precision, ion implantation tends to be very expensive since it requires the use of specialized and expensive semiconductor manufacturing equipment.

Likewise, the use of chemical vapor deposition (CVD) to add dopants may also have drawbacks. In a typical CVD process, a substrate (which can be an insulator, a semiconductor, or metal) is exposed to one or more volatile precursors, which react and/or decompose on the substrate surface to produce a doped film. However, like ion implantation, CVD is expensive since it requires specialized and expensive semiconductor manufacturing equipment. In addition, CVD also tends to be very slow, as the film layers are built up a single atom at a time.

Other common doping techniques include gas phase doping and spray type doping, both of which suffer from lack of ability to pattern simultaneous p-type and n-type doping.

In view of the foregoing, there is desired improved methods of producing Group IV junctions and devices therefrom, such as solar cells.

## SUMMARY

The invention relates to a device for generating electricity from solar radiation, comprising:

a wafer doped with a first dopant, the wafer including a front-side and a back-side, wherein the front-side is configured to be exposed to the solar radiation, the wafer further including a front-side diffused region, wherein the front-side diffused region is doped with a second dopant, the second dopant being a counter dopant to the first dopant;

a sintered Group IV nanoparticle BSF layer deposited on the back-side;

an electrode deposited on the back-side, wherein said electrode is in electrical contact with the fused Group IV nanoparticle BSF layer;

wherein when the solar radiation is applied to the front-side, an electrical current is produced.

## BRIEF DESCRIPTION OF THE DRAWINGS

The present invention is illustrated by way of example, and not by way of limitation, in the figures of the accompanying drawings and in which like reference numerals refer to similar elements and in which:

FIG. 1 shows a simplified diagram comparing surface area/volume to diameter for a set of Si nanoparticles, in accordance with the present invention;

FIG. 2 shows a simplified diagram of sphericity for a Group IV nanoparticle, in accordance with the present invention;

FIG. 3 shows a comparison of surface contamination and melting temperature to diameter for Si nanoparticles, in accordance with the present invention;

FIGS. 4A-C show a set of schematic diagrams of a concentric flow-through plasma reactor, in accordance with the present invention;

FIG. 5A shows a simplified diagram of a conventional diffused homogeneous emitter solar cell;

FIG. 5B shows a simplified diagram of a particle homogeneous emitter solar cell;

FIG. 5C shows a simplified diagram showing results of minority carrier measurements done on a p+ emitter wafer, an n+ BSF wafer, and a blank unpassivated silicon wafer as a control;

FIG. 5D shows a simplified diagram of an experimental current-voltage plot for the p+ particle planar emitter of FIG. 5B;

FIG. 5E shows a simplified diagram of a normalized quantum efficiency (QE) plot for the p+ particle planar emitter of FIG. 5B;

FIG. 5F shows a simplified diagram with a set of IV curves for the n-type silicon wafer substrates with the ink-deposition step omitted;

FIG. 5H shows a simplified quantum efficiency diagram measured on an asdeposited emitter and an etched-down emitter;

FIG. 5I shows a simplified diagram of experimental IV curves measured on an asdeposited emitter and an etched-down emitter;

FIG. 5J shows a simplified representative quantum efficiency diagram for devices with various emitter thicknesses, varied through spin-speed modification;

FIG. 5K shows a simplified diagram comparing the reflectivity of a p+ particle homogenous emitter wafer with the addition of an anti-reflective layer, to a p+ particle homogenous emitter wafer without an anti-reflective layer;

FIG. 5L shows a set of IV curves for the three larger area devices under AM1.5G illumination;

FIG. 5M shows a simplified diagram of experimental IV curves for a 20 cm$^2$ device under AM1.5G illumination;

FIGS. 6A-B show a set of simplified diagrams of selective emitter solar;

FIGS. 7A-B show a set of simplified diagrams of point junction solar cells; and

FIGS. 8A-B show a set of simplified diagrams of back-side point electrode solar cells.

## DETAILED DESCRIPTION

The present invention will now be described in detail with reference to a few preferred embodiments thereof as illustrated in the accompanying drawings. In the following description, numerous specific details are set forth in order to provide a thorough understanding of the present invention. It will be apparent, however, to one skilled in the art, that the present invention may be practiced without some or all of these specific details. In other instances, well known process steps and/or structures have not been described in detail in order to not unnecessarily obscure the present invention.

As previously described, current methods of forming junctions tend to be costly, difficult to pattern, and/or damaging to the substrate. In an advantageous manner, a set of Group IV nanoparticle layers may be created such that an efficient junction (*e.g.*, p-n, metal-silicon, etc.) may be formed at a lower cost, with easier patternability, and causing less damage to the substrate than with alternate methods.

A typical solar cell generally comprises at least two elements. First, an absorber region (typically a semiconductor) is configured to generate charge carriers (electrons and holes) by the absorption of light. And second, a set of junctions is configured to separate the charge carriers (in the case of a p-n junction), as well as to channel the charge carriers out of the solar cell (in the case of a metal-semiconductor junction).

Consequently, the amount of electricity produced by a solar cell is directly related to the efficiency of junctions within it. Junction efficiency generally reflects the ability to transfer and extract a substantial amount of the charge carriers across a boundary. Highly efficient junctions allow most charge carriers to cross, whereas inefficient junctions do not.

A free charge carrier is generally created only when an incoming photon has sufficient energy to free the carrier from its atom and the carrier thus conducts electricity. That is, for an electron to move from a valence energy band (valence band) to the conduction energy band (conduction band). In the valence band electrons are bound to the host atom. In contrast, in the conduction band, electrons (and their corresponding holes in the valence band) are free and have sufficient energy to function as charge carriers. Between the valence band and the conduction band is generally a range of energies that cannot be occupied by an electron, called the band gap.

If the band gap is large ($\sim > 5.0$ eV), the material is an insulator. If the band gap is small or non-existent ($\sim 0.0$ eV), the material is a metal. However, if the band gap is somewhere in the middle, then the material may function as a semiconductor. For example, Si has a band gap of about 1.12 eV.

As previously described, the Fermi level describes the energy level at given temperature in which ½ of the energy states are filled. Energy states are unique and correspond to a quantum number. Consequently, the addition of relatively small amounts of dopants to a semiconductor, such as a Group IV semiconductor, can increase the amount of electrically charged carriers. If an n-type dopant is added [*e.g.*, P (phosphorus), As (arsenic), Sb (antimony), etc.] the Fermi level is increased to a position closer to the conduction band. Likewise, when a p-type dopant is added [*e.g.,* B (boron), Ga (gallium), In (indium), etc.), the Fermi level is decreased to a position closer to the valence band.

In general, when a p-type region is placed next to an n-type region, a p-n junction is created. Consequently, as the Fermi levels of each region equilibrate, an electric field (or a built-in potential) tends to form. Electrons created on the p-type region (electron minority carriers) within the electric field may then be attracted to the n-type region and repelled from the p-type region, whereas holes created (hole minority carriers) on the n-type region within the electric field may then be attracted to the p-type region and repelled from the n-type region. These minority carriers may then be channeled out of the solar cell to create electricity.

As electron-hole pairs are generated, each is available to diffuse through the lattice until it comes under the influence of an electric field near an n-type region or p-type region respectively and eventually being extracted by the contacts in the external circuit. However, imperfections within the p-type region, n-type region, the absorber, or at their interface, can create charge traps by destroying minority carriers.

Breaks in the lattice structure, the existence of interstitial atoms (within the crystal structure but not at a lattice site), or contaminants (*e.g.*, oxygen, oxygen complexes, etc.), may create intermediate energy states in the band gap, below the conduction band. Consequently, the minority carriers recombine instead of being channeled out of the solar cell, and thus are unavailable to generate electricity.

A crystal lattice structure (*e.g.*, Si wafer, etc.) is thus preferred as absorbers to minimize recombination in photovoltaic applications. For example, a Si wafer (absorber) may be first created as n-type or p-type, and then infused on one side using an appropriate technique (*e.g.*, through chemical vapor deposition, ion implantation, gas-phase diffusion, spray-on diffusion, spin-on diffusion, doped glass, etc.) with the opposite dopant, n-type (n+) or p-type (p+) respectively, in order to create a p-n junction. However, as previously stated, this diffusion process tends to be expensive and inflexible to patterning.

In addition, as previously stated, depositing doped glass may be problematic. For example, doped glass is often applied via a silk-screen. Silk-screening is generally a printing technique that makes use of a squeegee to mechanically force a liquid, such as a highly doped glass paste, directly onto a substrate. Consequently, this downward mechanical force tends to subject the substrate to additional stresses, and hence may detrimentally affect the electrical and physically characteristics of the substrate.

In addition, creating alternating n-type and p-type regions on the same side of the substrate with a doped glass, such as with back contact solar cells, requires multiple screen printing steps. In general, every additional screen printing step may reduce the process yield due to damage or breakage during printing or handling. Wafer breakage can also cause production line downtime, further increasing costs. A buffered oxide etch (BOE) is generally required to strip off the oxide film that is formed during the screen printing dopant diffusion process.

Aligning a subsequent screen pattern to existing patterns on the substrate also presents substantial challenges. For example, if pattern alignment is poor, the resulting solar cells may malfunction (short) further reducing process yield.

Furthermore, metal-semiconductor junctions also tend to be problematic. As with p-n junctions, Fermi levels in metal-semiconductor junctions also tend to equilibrate, creating a potential barrier between the metal region and the doped semiconductor region. Consequently, placing a heavily doped n-type region (n++) or the p-type region (p++) next to a metal region helps to form an ohmic (low-resistance) contact through quantum tunneling and/or thermally assisted tunneling.

However, the addition of dopants can also decrease the charge carrier diffusion length. Diffusion length is generally the average distance a carrier can move from point of generation until it recombines. Consequently, regions of the solar cell that contact metal are difficult to optimize, as greater dopant concentration increases the efficiency of the metal-semiconductor boundary, but also decreases carrier diffusion length. That is, more of the carriers that get to the metal-semiconductor boundary will cross, but fewer of the carriers ever get that far.

In an advantageous manner, multiple regions of varying dopant concentrations may be used to optimize boundary efficiency and carrier diffusion length.

## Characteristics of Group IV Nanoparticles

In general, a nanoparticle is a microscopic particle with at least one dimension less than 100 nm. The term "Group IV nanoparticle" generally refers to hydrogen terminated Group IV nanoparticles having an average diameter between about 1 nm to 100 nm, and composed of silicon, germanium, carbon, or combinations thereof. The term "Group IV nanoparticle" also includes Group IV nanoparticles that are doped.

In comparison to a bulk material (> 100 nm) which tends to have constant physical properties regardless of its size (*e.g.*, melting temperature, boiling temperature, density, conductivity, etc.), nanoparticles may have physical properties that are size dependent, and hence useful for applications such as junctions. For example, semiconductor nanoparticles may be more easily and cheaply patterned into forming p-n junctions when compared to alternate methods, such as silk-screening or deposition.

However, because they have substantially larger surface areas in comparison to bulk solids, Group IV nanoparticles also tend to be very susceptible to contamination. In general, since it is extremely difficult to completely prevent ambient oxygen or water molecules from coming into contact with the Group IV nanoparticles, contamination often occurs from such chemical reactions such as oxidation and/or hydrolysis. Consequently, even small amounts of contamination may inhibit sintering *(i.e., interfering with the physical connection of the Group IV nanoparticles), delay dense layer formation (i.e., increasing material porosity and thus decreasing conductivity), and provide electron-hole recombination sites (i.e., attenuating current generation in the assembled junction).

In an advantageous manner, the Group IV nanoparticles may be formed into a substantially spherical shape in order to minimize contamination. In general, of all the solids having a given volume, a sphere is the one with the smallest surface area. Likewise, of all solids having a given surface area, the sphere is the one having the greatest volume. Consequently, a spherical nanoparticle will tend to shield the greatest number of Group IV atoms from contamination, and hence is beneficial to junction creation.

In general, semiconductor nanoparticles typically must be formed into dense connected regions in order to create a junction. One such method is sintering. Generally a method for making particles adhere to each other, interacting nanocrystals sinter before size-dependent melting occurs. A.N. Goldstein, *The melting of silicon nanocrystals: Submicron thin-film structures derived from nanocrystal precursors,* APPLIED PHYSICS A., 1996. Consequently, Group IV nanoparticles that are substantially spherical and preferably between about 4 nm and about 100 nm in diameter tend to sinter at lower temperatures, and hence are beneficial to create junctions. In yet another configuration, the Group IV nanoparticles are substantially spherical and more preferably between about 4.0 nm and about 20.0 nm in diameter. In yet another configuration, the Group IV nanoparticles are substantially spherical and most preferably 7.0 nm.

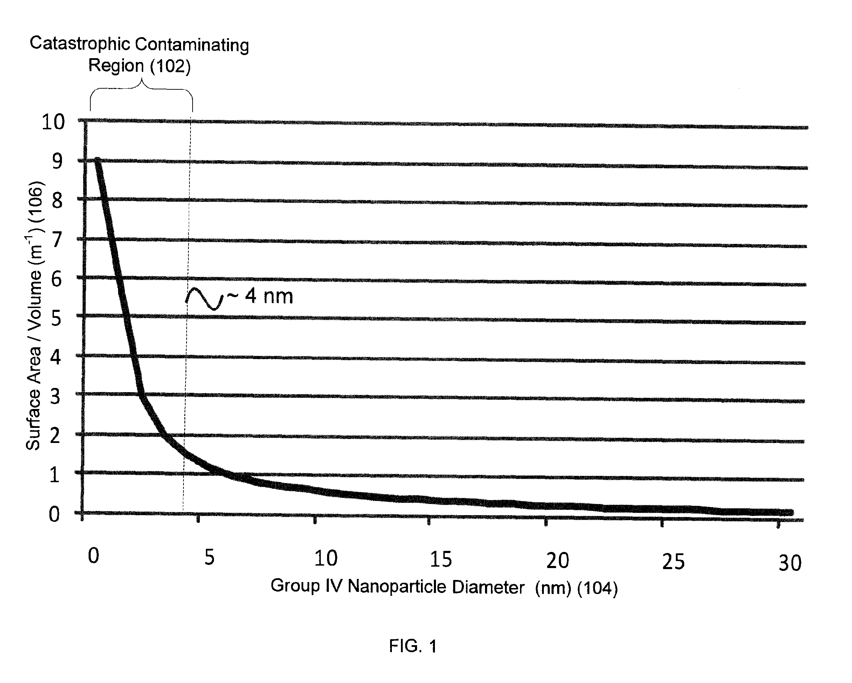

Referring now to FIG. 1. a simplified diagram is shown comparing surface area/volume to diameter for a set of Si nanoparticles, in accordance with the present invention. Horizontal axis 104 shows Si nanoparticle diameter in nanometers, whereas vertical axis 106 shows Si surface area/volume in meters$^{-1}$.

In general, Si atoms have an atomic radius of about 0.118 nm and tend to form a diamond crystal structure with a cell dimension of about 0.5431 mm. In addition, although not shown, Ge with an atomic radius of about 0.125 nm and a cell dimension of about 0.566 nm, will have a area/volume to diameter curve that is substantially similar to that of Si.

Below about 4 nm, in the catastrophic contaminating region 102, the surface area/volume ratio starts to substantially increase, from about 1.5 m$^{-1}$ (at about 4 nm) to about 6.0 m$^{-1}$ (at 1 nm). Eventually, all of the Si atoms are essentially surface or shell atoms, and the likelihood of contamination is extremely high. Thus, for purposes of contamination reduction, Group IV nanoparticles should be greater than about 4 nm in diameter.

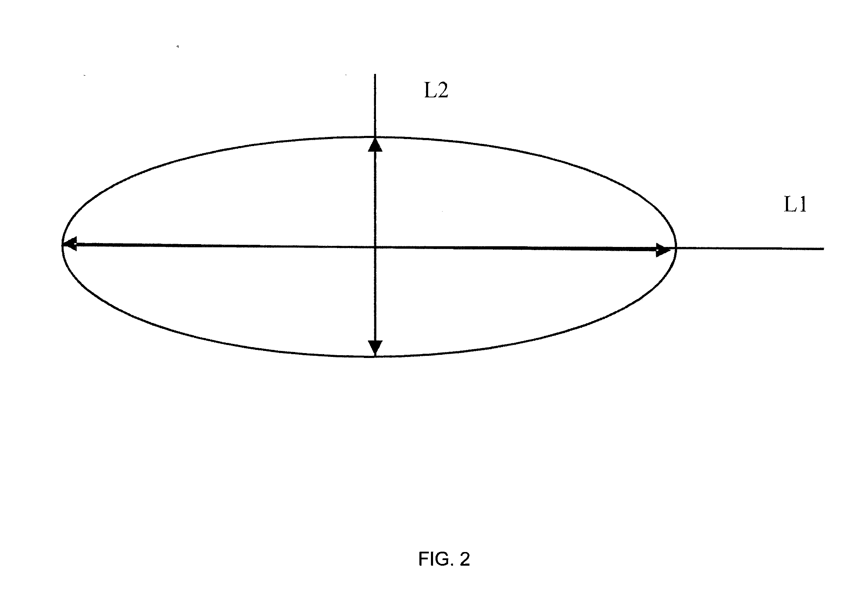

Referring now to FIG. 2, a simplified diagram showing sphericity for a Group IV nanoparticle is shown, in accordance with the present invention. In general, a metric for particle shape uniformity or sphericity may be obtained by using transmission electron microscopy images. A transmission electron microscopy (TEM) is an imaging technique whereby a beam of electrons is transmitted through a specimen, then an image is formed, magnified and directed to appear either on a fluorescent screen or layer of photographic film or to be detected by a sensor such as a CCD camera.

Particle sizes may be measured by identifying individual particles and drawing a straight line across a particle's shortest and longest dimensions as shown in the graphical example. Uniformity may be defined as the ratio of the maximum diameter over the minimum diameter of a particle. By measuring the particle dimension defined as the ratio of the longest L1 over the shortest dimension L2, one can obtain the metric L1/L2 as the level of sphericity. For example, for an ideal spherical particle, uniformity is equal to about 1.0. For an irregular particle, uniformity is generally substantially larger than about 1.0. For example, if a particle is rod or needle shaped, the L1/L2 ratio may be greater than 5. Optimal sphericity is generally between about 1.0 and about 2.0. Aside from surface contamination, a L1/L2 ratio of below 2 is beneficial to nanoparticle application techniques, such as inkjet printing.

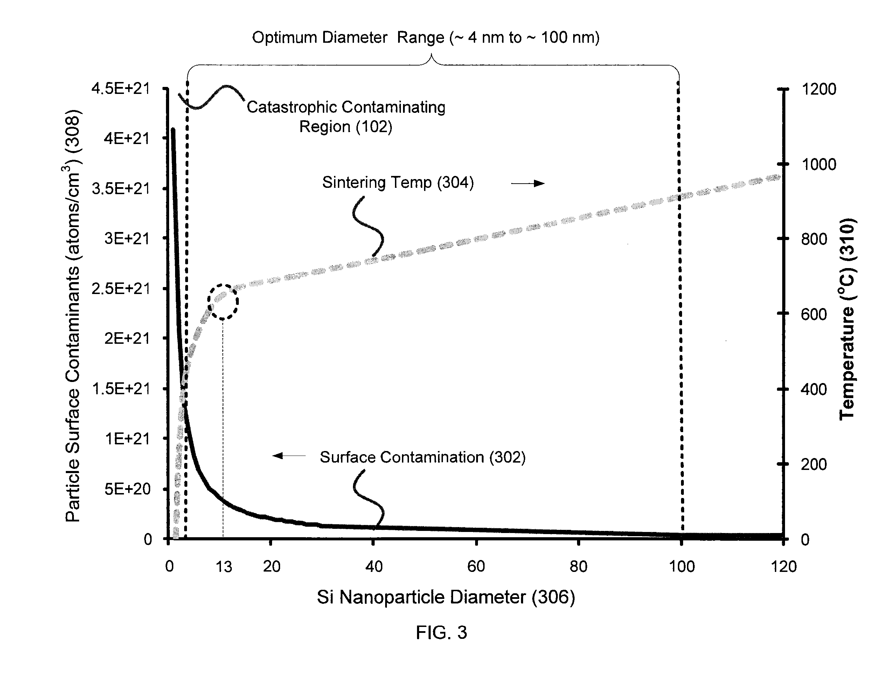

Referring now to FIG. 3, surface contamination and melting temperature are compared to diameter for Si nanoparticles, in accordance with the present invention. Horizontal axis 306 shows Si nanoparticle diameter. Left-side vertical axis 308 shows particle surface contaminants whereas right-side vertical axis 310 shows temperature in °C

At about a 4 nm diameter, Si particle surface contamination is about 1.02 x 10$^{21}$ atoms/cm$^3$, corresponding to a surface area/volume ratio of about 1.5 m$^{-1}$ as previously shown. As the Si particle surface contamination increases above about 1.02 x 10$^{21}$ atoms/cm$^3$ in the catastrophic contaminating region (102), sintering, dense layer formation, and electron-hole recombination are aggravated, as previous stated.

In contrast, below about 13 nm, the sintering temperature of a Si nanoparticle sharply decreases with corresponding decrease in diameter size. Above about 13 nm, it is believed that the sintering temperature gradually increases with a corresponding increase in diameter size, eventually reaching about 947 °C, or 67% of the melting temperature of Si (about 1414°C). Likewise, although not shown in the figure, for germanium, it is believed that the sintering temperature also gradually increases with a corresponding increase in diameter size, eventually reaching about 628 °C, or 67% of the melting temperature of Ge (about 938°C).

As previously described, sintering is generally a method for making particles adhere to each other and inducing densification of films. Consequently, because their small radii of curvature, it is believed that nanoparticles generally begin to sinter when a temperature of about 2/3 of the particle melting point is reached. It is further believed that large shear stresses generated by elevated temperatures in neck regions of the nanoparticles tend to cause a plastic deformation between two proximately located nanoparticles. For a given nanoparticles material, smaller nanoparticles generally have a lower sintering temperature than that of larger nanoparticles.

In general, various heat sources maybe used to sinter the nanoparticle, such as conventional contact thermal sources (*e.g.*, resistive heaters, etc.), as well as radiative heat sources (*e.g.*, lamps, lasers, microwave processing equipment, plasmas, tungsten-halogen, continuous arc lamps, flash lamps, etc.). In the case of lasers, a wavelength range of between about 0.3 microns and about 10 microns is generally optimal.

In advantageous manner, lowering the sintering temperature reduces thermally induced stress in the underlying substrate that may subsequently damage the wafer and reduce minority carrier lifetime in photo-voltaic applications.

Additionally, a lower sintering temperature also allows the use of alternative materials in or near the junction (i.e., substrate, dielectric layer, etc.) that may have a melting point substantially below the Group IV melting temperature. For example, polymides (e.g., Kapton, Kaptrex, etc.), with a glass temperature of around 400°C, maybe used both as a dielectric and as a mask for production of electrical junctions. In addition, lowering the sintering temperature may allow film formation without further diffusion of dopants that are already diffused into or otherwise positioned within the PV cell structure. Consequently, by reducing the Group IV nanoparticle diameter sufficiently (to about 7 nm in this example), a dense nanoparticle layer may be formed on a polymide layer.

## Characteristics of Group IV Nanoparticle Colloidal Dispersions (Inks)

Furthermore, smaller particles may be more readily suspended in a colloidal dispersion. Because of their small size, nanoparticles tend to be difficult to manipulate. Consequently, in an advantageous manner, assembled nanoparticles may be suspended in a colloidal dispersion or colloid, such as an ink, in order to transport and store the nanoparticles.

Generally, colloidal dispersions of Group IV nanoparticles are possible because the interaction of the particle surface with the solvent is strong enough to overcome differences in density, which usually result in a material either sinking or floating in a liquid. That is, smaller nanoparticles disperse more easily than larger nanoparticles.

In general, the Group IV nanoparticles are transferred into the colloidal dispersion under a vacuum, or else an inert substantially oxygen-free environment. In addition, the use of particle dispersal methods and equipment such as sonication, high shear mixers, and high pressure/high shear homogenizers may be used to facilitate dispersion of the nanoparticles in a selected solvent or mixture of solvents.

Examples of solvents include alcohols, aldehydes, ketones, carboxylic acids, esters, amines, organosiloxanes, halogenated hydrocarbons, and other hydrocarbon solvents. In addition, the solvents may be mixed in order to optimize physical characteristics such as viscosity, density, polarity, etc.

In addition, in order to better disperse the Group IV nanoparticles in the colloidal dispersion, nanoparticle capping groups may be formed with the addition of organic compounds, such as alcohols, aldehydes, ketones, carboxylic acids, esters, and amines, as well as organosiloxanes. Alternatively, capping groups may be added in-situ by the addition of gases into the plasma chamber. These capping groups may be subsequently removed during the sintering process, or in a lower temperature pre-heat just before the sintering process.

For example, bulky capping agents suitable for use in the preparation of capped Group IV semiconductor nanoparticles include C4-C8 branched alcohols, cyclic alcohols, aldehydes, and ketones, such as tertiary-butanol, isobutanol, , cyclohexanol, methyl-cyclohexanol, butanal, isobutanal, cyclohexanone, and oraganosiloxanes, such as methoxy(tris(trimethylsilyl)silane)(MTTMSS), tris(trimethylsilyl)silane (TTMSS), decamethyltetrasiloxane (DMTS), and trimethylmethoxysilane (TMOS).

Once formulated, the colloidal dispersion may be applied to a substrate and subjected to a heat treatment in order to sinter the Group IV nanoparticles into a densified conductive film. Examples of application methods include, but are not limited to, roll coating, slot die coating, gravure printing, flexographic drum printing, and inkjet printing methods, etc.

In one particular configuration, in an advantageous manner, the colloidal dispersion may be applied in patterned regions by an inkjet printer. Inkjet printers generally are configured with a piezoelectric material in an ink-filled chamber behind each nozzle. When a voltage is applied, the crystal changes shape or size, which generates a pressure pulse in the fluid forcing a droplet of ink from the nozzle.

In the case of Group IV nanoparticles, the colloidal dispersions should disperse well in the selected solvents and should easily filter though a 0.5 $\mu$m filter (more preferably through a 0.3 $\mu$m filter), in order to optimize printability (typically the unit of "microns" is used for filters).

Additionally, various configurations of doped Group IV nanoparticle colloidal dispersions can be formulated by the selective blending of doped, undoped, and/or differently doped Group IV nanoparticles. For example, various formulations of blended Group IV nanoparticle colloidal dispersions can be prepared in which the dopant level for a specific layer of a junction is formulated by blending doped and undoped Group IV nanoparticles to achieve the requirements for that layer. Alternatively, the blended Group IV nanoparticle colloidal dispersions may be used to compensate for substrate defects, such as the passivation of oxygen atoms in order to reduce undesirable energy states.

Furthermore, in an advantageous manner, doped nanoparticles may themselves be used as a carrier to diffuse dopants into the wafer. That is, in a similar fashion to the use of doped glass as described above, a colloidal dispersion of doped nanoparticles (n-type or p-type respectively) may be deposited on the wafer with an appropriate deposition technique such as inkjet printing, and then heated in order to diffuse the dopant into the wafer. Consequently, since the nanoparticle deposition is itself conductive (unlike the doped glass) BOE is not required for its removal. Thus, a liquid batch process step may be eliminated improving production yield.

## Apparatus for Manufacturing Group IV Nanoparticles

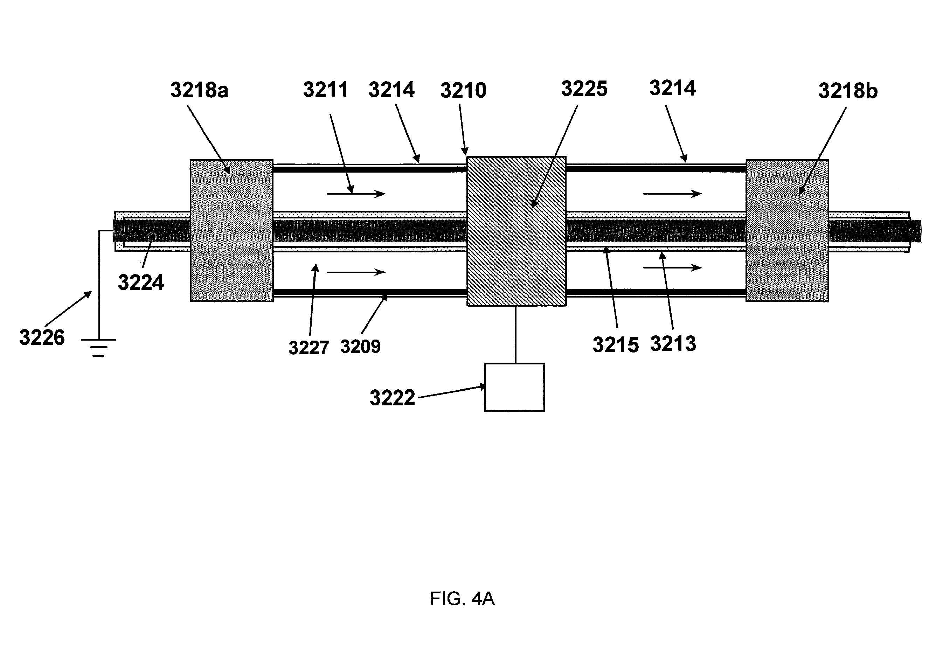

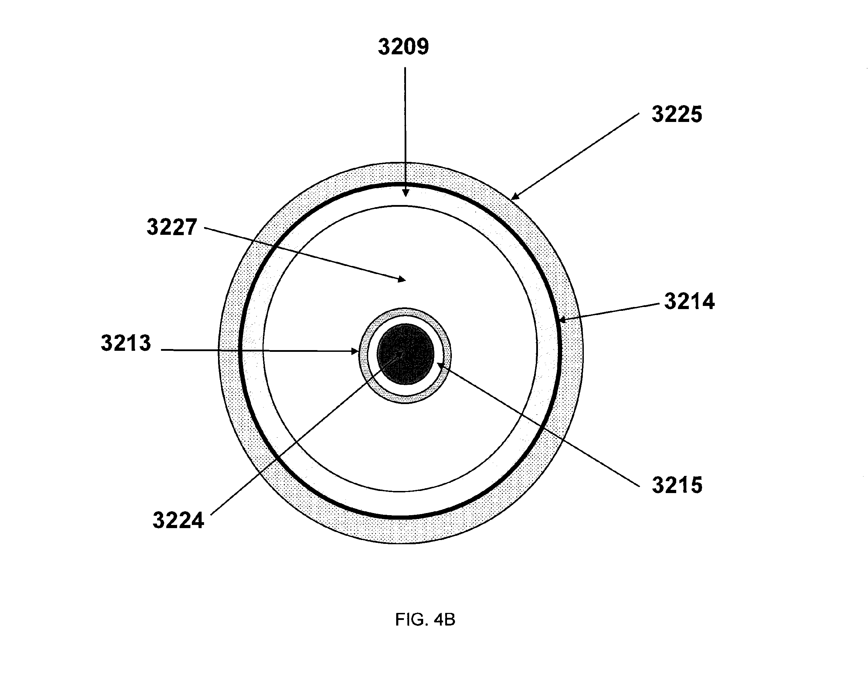

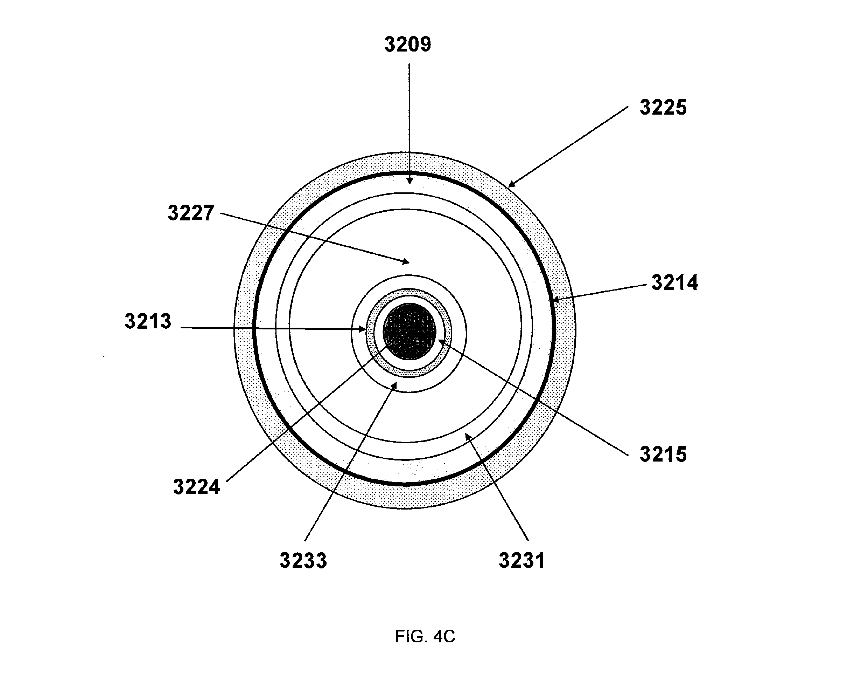

Referring now to FIGS. 4A-C, a set of schematic diagrams of a concentric flow-through plasma reactor is shown. FIG. 4A shows a side view. FIG. 4B shows a cross-sectional view. FIG. 4C shows the cross-sectional view of FIG. 4B with the addition of a coating on a first dielectric and a second dielectric.

In general, a Group IV precursor gas, a set of inert gases, as well as a dopant gas (if required), are generally flowed through the annular channel and ignited in a reaction zone between a set of electrodes. An RF (radiofrequency) signal is then applied to the powered electrode in order to strike a plasma and subsequently dissociate and form Group IV nanoparticles which are generally collected downstream of the reaction zone.

In general, the concentric flow-through plasma reactor is configured with an outer tube **3214** and an inner tube **3215** concentrically positioned along a longitudinal axis with respect outer tube **3214**. An annular channel **3227,** defined by the area inside outer tube **3214** and outside inner tube **3215,** may be sealed from the ambient atmosphere by inlet port flange **3218a** and outlet port flange **3218b.**

A plasma reaction zone (*i.e.,* the zone in which the nanoparticles are created) is defined as an area inside annular channel **3227** between a tube-shaped outer electrode **3225** (positioned outside outer tube **3214)** and a tube-shaped central electrode **3224** (central electrode tube), positioned concentrically along a longitudinal axis with respect to tube-shaped outer electrode **3225** (outer electrode tube), and further positioned inside inner tube **3215.** Typically, the precursor gas or gases may be introduced into annular channel **3227** along flow path **3211** from a precursor gas source in fluid communication with an inlet port (not shown) on inlet port flange **3218a.** Similarly, nanoparticles produced within the plasma reactor chamber may exit through an exit port (not shown) on outlet port flange **3218b** into a nanoparticle collection chamber (not shown). Alternatively, the nanoparticles may be collected on a substrate or grid housed in the plasma reactor chamber.

In general, tube-shaped central electrode **3224** is configured to extend along a substantial portion of the plasma reactor. In additional, tube-shaped central electrode **3224** and tube-shaped outer electrode **3225** may be made of any sufficiently electrically conductive materials, including metals, such as copper or stainless steel.

Outer tube **3214** may be further shielded from the plasma by outer tube dielectric layer **3209** disposed on the inner surface of outer tube **3214**. In general, outer tube **3214** may be any material that does not substantially interfere with the generated plasma, such as a dielectric material. In an embodiment, outer tube **3214** and outer tube dielectric layer **3209** are comprised of different materials, such as different dielectric materials. In an alternate embodiment, outer tube **3214** and outer tube dielectric layer **3209** are the same physical structure and material, such as quartz. Likewise, inner tube **3215** may be further shielded from the plasma by inner tube dielectric layer **3213**. Examples of dielectric materials include, but are not limited to, quartz, sapphire, fumed silica, polycarbonate alumina, silicon nitride, silicon carbide, and borosilicate.

In general, plasma reactor conditions during nanoparticle synthesis have a significant impact on the properties and structure of produced nanoparticles. During the nucleation and growth stages of particles synthesis, each individual particle will have a temperature that will depend on the applied plasma power, reactor pressure, and gas composition and reactor geometry.

Typically, Group IV nanoparticles produced below a certain temperature will be amorphous, whereas particles produced such that they are hotter during synthesis are crystalline. In addition to crystallinity, particle temperature during synthesis will affect dopant activation. Doped nanoparticles that were exposed to higher temperature during synthesis will have dopants that are electrically active, as opposed to the electrically inactive dopants in the low-temperature produced particles. By controlling the plasma synthesis parameters of doped Group IV particles it is possible to modify their electrical and structural properties.

A variety of dopant gases are possible for use for creating doped Group IV nanoparticles. Examples of Group IV precursor gases include silane, disilane, germane, digermane, halide analogs, etc. Examples of n-type dopant gases include phosphine, arsine, etc. Examples of p-type dopant gases include boron diflouride, trimethyl borane, diborane, etc. Examples of the inert gases include argon, helium, neon, etc.

In one configuration, Group IV nanoparticles may be produced in an RF plasma at a total pressure of no greater than about 25 Torr (3.3 kPa) (*e.g.,* about 3 Torr to about 25 Torr (400 Pa to 3.3 kPa)). Typical flow rates for the semiconductor precursor gas may be about 2 standard cubic centimeters (seem) to about 30 sccm, while the flow rate for a dopant gas maybe about 60 sccn to about 150 sccm (*e.g.,* about 0.1% of dopant in inert buffer gas such as Ar). Typically, the ratio of semiconductor precursor gas molecules to dopant gas molecules in the plasma reaction is from about 25:1 to about 1000:1.

The frequency of the RF power source used to ignite and/or sustain the RF plasma may vary within the RF range from 300 kHz to 300 GHz. Typically, however, a frequency of 13.56 MHz will be employed because this is the major frequency used in the radiofrequency plasma processing industry. Typical radiofrequency powers range from about 30 W to about 300 W.

The concentration of dopants in the Group IV nanoparticles may vary depending on factors such as dopant gas concentration and flow rate. For example, silane or germane may be used as the Group IV precursor gas and phosphine may be used as the dopant gas in the present methods to produce phosphorous-doped silicon nanoparticles. However, the present radiofrequency plasma-based methods are capable of producing Group IV nanoparticles having dopant concentrations approaching the solubility limit of the dopant in a crystalline semiconductor.

For example, in the case of crystalline Si nanoparticles, the present methods can provide p-type (*e.g.*, phosphorous or arsenic) doping levels of at least about 2%. This includes embodiments wherein the p-type dopant level in silicon nanoparticles is between about 0.01% and about 5%.

Similarly, the present methods can provide n-type silicon nanoparticles with doping levels of at least about 1%. This includes embodiments wherein the n-type dopant level is between about 0.01% and about 5%.

In one configuration, doped Group IV nanoparticles may be formed as crystalline nanoparticles with activated dopants. This configuration is advantageous because it may eliminate the need for a high-temperature dopant activation step, thereby rendering the method less expensive, less time-consuming and more efficient.

Furthermore, the present methods can generate nanoparticles within a substantially narrow nanoparticle size distribution. For example, a set of p-type and intrinsic nanoparticles were prepared in an RF reactor substantially similar to that described for FIGS. 4A-C. For the p-type nanoparticles, a 10% silane gas in argon was used at a flow rate of 22.5 sccm. A dopant gas of diborane was used at a concentration of 100 ppm at flow rate of 75 seem, providing a ratio of boron to silicon in the reactor of about 0.66%. The pressure in the RF plasma reactor chamber was maintained at about 10 Torr (1.3 kPa).

For the intrinsic nanoparticles, a 10% silane gas in argon was used at a flow rate of 22.5 seem. As before, the pressure in the RF plasma reactor chamber was maintained at about 10 Torr (1.3 kPa).

The resulting nanoparticle size distribution for the p-type silicon nanoparticles was 5.2 nm +/- 1.0 nm, while the size distribution for the intrinsic silicon nanoparticles was 5.7 nm +/- 1.2 nm.

## Configurations for Solar Cells Manufactured With Group IV Nanoparticles

In general, the following device configuration may be alternated. For example, a p-type wafer with an n-type emitter may be reversed, such that an n-type wafer with a p-type emitter may be used.

## A. Homogenous Emitter Solar Cell

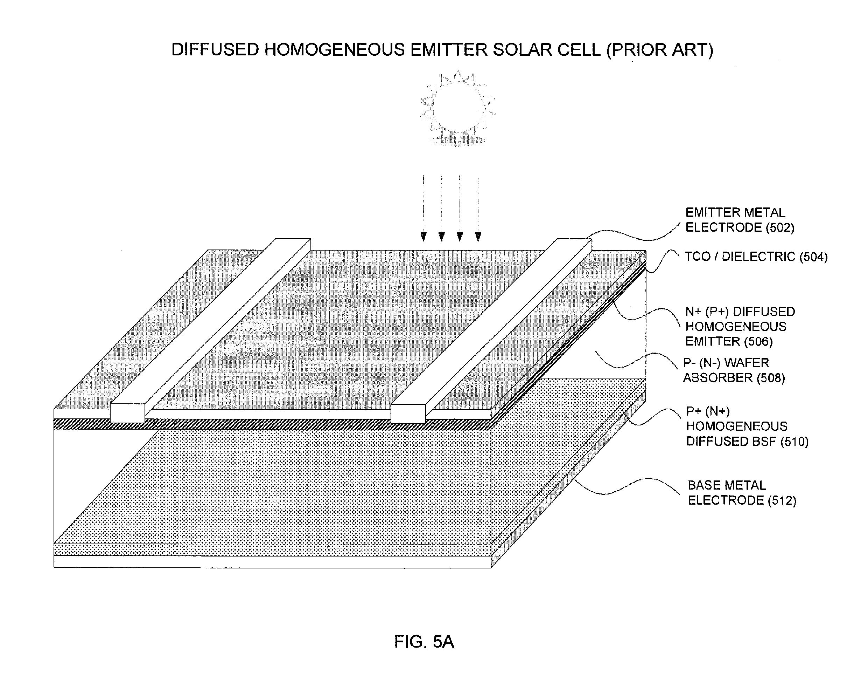

Referring now to FIG. 5A, a simplified diagram of a conventional diffused homogeneous emitter solar cell is shown. In general, diffused homogeneous emitter n+ (or p+) 506 is deposited on a wafer absorber 508 p- (or n-) in order to create the p-n junction required for charge separation and extraction.

Further deposited on top of diffused homogeneous emitter 506 is generally either a TCO (transparent conductive oxide) or a dielectric (TCO/dielectric 504). TCO helps improve the conductivity of the solar cell by providing a conductive path for generated charge carriers to reach an electrode. In contrast, a dielectric (SiN, SiO$_2$, etc.) helps passivate the surface of diffused homogeneous emitter 506, minimizing both contamination of the wafer bulk from external sources, as well as substantially reduce minority carrier recombination caused by dangling Si bonds or imperfections in the wafer absorber 508 surface.

An emitter metal electrode 502 (typically made out of printed silver paste) is generally positioned above and in electrical contact with the diffused homogenous emitter 506 (typically through a channel or cavity in a dielectric or directly on top of an ITO 504). Emitter metal electrode 502 is generally optimized to extract the charge carriers (here electrons) created in the wafer when light is absorbed. This is done by having both a reduced horizontal surface area (thus minimizing losses due to shading, which tend to reduce the generated current), and an increased cross-sectional volume (thus reducing the series resistance of the device, which tends to increase the efficiency of the device).

The back-side of wafer absorber 508 is often configured with a heavily doped region (of the same type as the wafer) which creates an homogenous diffused BSF layer (back surface field) 510. Minimizing the impact of rear surface recombination, a properly configured BSF tends to repel those oppositely charged carriers that are located closer to the back-side. That is, the interface between homogenous diffused BSF layer 510 and wafer absorber 508 tends to introduce a barrier to minority carrier flow to the rear surface, resulting in higher levels of minority carrier concentrations in the wafer absorber. For example, A1 (aluminum) or B (boron) may be added to a p-type wafer to repel electrons. In contrast, for an n-type wafer, P (phosphorous) may be added to repel holes.

In addition, a base metal electrode 512 is generally added to the back-side of wafer absorber 508 (or diffused BSF 510 as appropriate) in order to extract the majority charge carriers (here holes). Typically comprising two metals, lower cost A1 sheet is applied to cover most of the surface, whereas higher cost Ag pads are generally inserted in order to facilitate soldering for interconnection into modules. In addition, base metal electrode 512 also serves as a mirror to reflect long wavelength light back into the cell for additional passes through the absorber.

Typically, a solar cell configured with a diffused homogeneous emitter solar cell has a power conversion efficiency of about 15%. In general, efficiency ($\eta$) is defined as the ratio of energy output from the solar cell to input energy $P_{in}$ from the sun:

$$\eta = \frac{V_{OC} I_{SC} FF}{P_{in}}$$

where $V_{OC}$ is the open-circuit voltage; $I_{SC}$ is the short-circuit current; and FF is the fill factor.

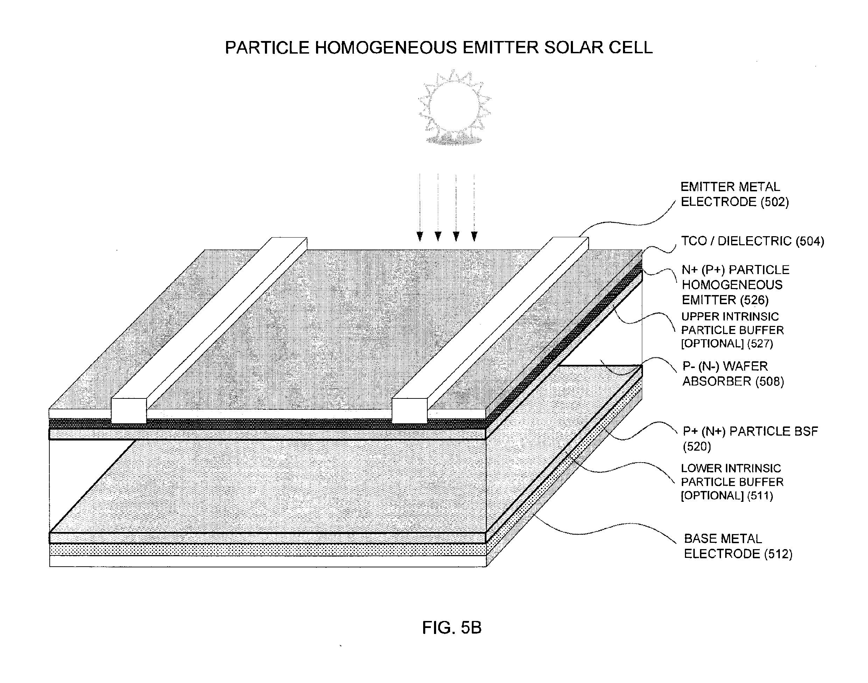

Referring now to FIG. 5B, a simplified diagram of a particle homogeneous emitter solar cell is shown. While not wishing to be bound by theory, it is believed by the inventors that by replacing the homogenous diffused p+ (n+) BSF layer 510 of FIG. 5A with p+ (n+) fused particle BSF 520, an efficient solar cell may be created at about the same or lower cost as a conventional solar cell.

Furthermore, the use of particle layers as a BSF may avoid wafer bowing when using thin wafers, which is a common problem in device structures comprising diffuse layers, caused by mismatch in thermal expansion coefficients during high temperature processing steps, such as aluminum BSF formation.

In the following alternate configurations which do not fall under the scope of claim 1 and therefore are not part of the present invention, an optional upper intrinsic particle buffer 527 may be placed between a p- (n-) wafer absorber 508 and an n+ (p+) particle homogeneous emitter 526. Alternatively, an optional lower intrinsic particle buffer 511 may also be placed between the p- (n-) wafer absorber 508 and the p+ (n+) fused particle BSF 520.

All particle layers (n+ (p+) particle homogeneous emitter 526, p+ (n+) fused particle BSF 510, and upper intrinsic particle buffers 527, and lower intrinsic particle buffer 527) may be directly deposited onto p- (n-) wafer absorber 508 with an appropriate deposition technique, such as contactless deposition (*e.g.*, inkjet printing, spin coating, doctor blading, gravure deposition, etc.). Consequently, costly or stress-inducing doping techniques may be avoided.

For example, n+ (p+) particle homogeneous emitter 526 may be deposited at room temperature and at atmospheric pressure. Alternatively, n+ (p+) particle planar emitter 526 may be deposited in a nitrogen environment (< 0.1 ppm of oxygen and < 0.1 ppm of water) by inkjet printing. After deposition, a sintering (densification) process may be used to neck the particles together in order to form a contiguous semiconductor layer.

In one configuration, a short thermal process of about 400-1100°C for about 5 to 20 seconds may be used in an RTP (rapid-thermal-processing) tool to densify or sinter the particle layers (*e.g.,* n+ (p+) particle homogeneous emitter 526, first optional intrinsic particle buffer 527, p+ (n+) fused particle BSF 520, and second optional intrinsic particle buffer 511). Alternative processes leading to sintering, which could also be used include firing in a furnace (*e.g.,* a belt furnace, batch tube furnace, etc.), firing in a vacuum environment, or using a fast flash system. In yet another alternative configuration, the sintering process of the particle layers may be accomplished using a laser. These and other sintering methods are disclosed in U.S. Pat. App. No. 60/874,873, entitled *EPITAXIAL THIN FILM FABRICATION FROM GROUP IV SEMICONDUCTOR,* filed December 13, 2006, the entirety of which is incorporated herein by reference.

## Example 1

To ensure high solar cell device performance, a printed layer is expected to provide an adequate level of surface passivation when deposited onto the wafer. It is widely accepted that a measurement of minority carrier effective lifetime is a reliable technique to assess passivation properties of diffused layers on the wafers, see A. Cuevas and D, MacDonald, *Measuring and interpreting the lifetime of silicon wafers,* 76 SOLAR ENERGY 255 (2004).

In general, better passivation quality translates to a higher value of the open circuit voltage, $V_{OC}$, of a corresponding solar cell, thus meaning higher efficiency. This example shows the passivation properties of printed p+ emitter and of printed n+ BSF layers, used on n-type silicon wafers.

In this example, 1" x 1" x 0.012" (2.54 cm x 2.54 cm x 0.03 cm) double-sided-polished silicon wafer substrates doped with phosphorus to a resistivity of about 10 to 20 Ohm·cm were cleaned by treatment with NaOH, SC2, Buffered Oxide Etch (BOE), and Piranha, respectively.

For p+ emitter formation, a silicon nanoparticle ink was prepared in an inert environment from boron-doped silicon nanoparticles of about 10.0 nm +/- 0.5 nm as a 20 mg/ml solution of chloroform:chlorobenzene (4:1 by volume), which was sonicated using a sonication horn at 15% power for 15 minutes. Applying sufficient silicon nanoparticle ink to substantially cover the wafer surface, a silicon nanoparticle porous compact was sequentially formed on both sides of the substrates using spin casting, at a spin-speed of 1000 rpm for 60 seconds, followed by baking in an inert environment on a hotplate at 100°C for 30 minutes. After the deposition and preconditioning steps were complete, the nanoparticle porous compact was processed at 1000°C for 20 seconds in a rapid-thermal-processing tool to neck the p+ particles together in order to form a contiguous semiconductor layer.

For n+ BSF formation, a silicon nanoparticle ink was prepared in an inert environment from phosphorus-doped silicon nanoparticles of about 10.0 nm +/- 0.5 nm as a 40 mg/ml solution of cyclohexanol:cyclohexanone (1:1 by volume), which was sonicated using a sonication horn at 15% power for 15 minutes. A silicon nanoparticle porous compact was formed using inkjet printing with a dot spacing of 2000 dpi (dots per inch (2.54 cm)), followed by baking in an inert environment on a hotplate at 100°C for 30 minutes. After the deposition and preconditioning steps were complete, the nanoparticle porous compact was processed at 1000°C for 20 seconds in a rapid-thermal-processing tool to neck the p+ particles together in order to form a contiguous semiconductor layer.

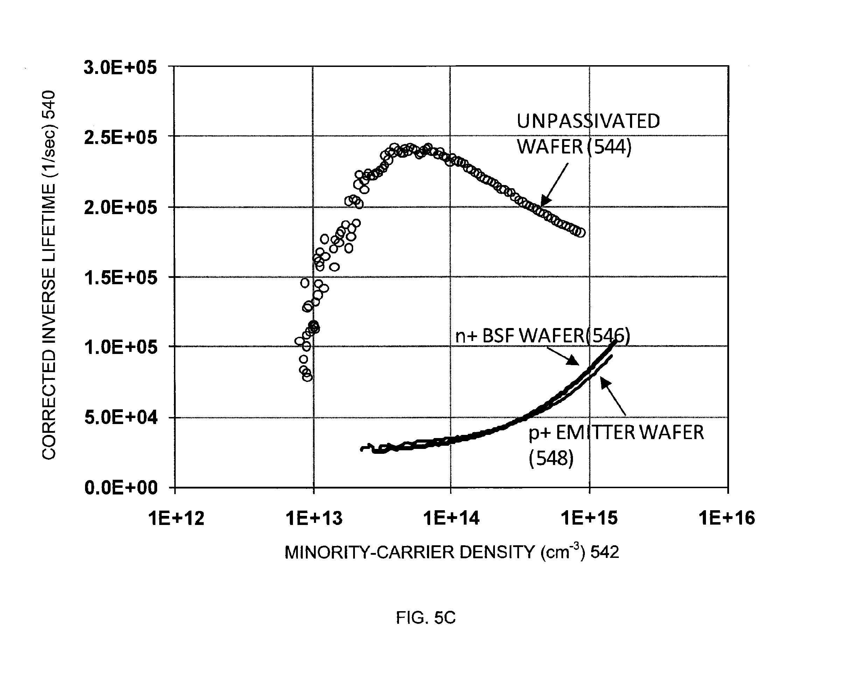

Referring now to FIG. 5C, a simplified diagram showing results of measurements done on a p+ emitter sample 548 (fabrication as described above), an n+ BSF sample 546 (fabrication as described above), and a blank unpassivated silicon wafer sample 544 as a control.

Corrected inverse lifetime (measured in 1/sec) 540 was calculated from the results of the quasi-steady-state photoconductance (QSSPC) measurements and is presented as a function of increasing minority-carrier density (measured in $cm^{-3}$) 542. It is clear that both p+ emitter sample 548 and n+ BSF sample 546 provide adequate levels of passivation, which are also significantly better than the passivation provided by the exposed surface of a blank wafer sample. This is expressed by a much lower effective lifetime for the latter (or higher inverse lifetime), being totally dominated by the poor surface passivation properties of the wafer.

## Example 2

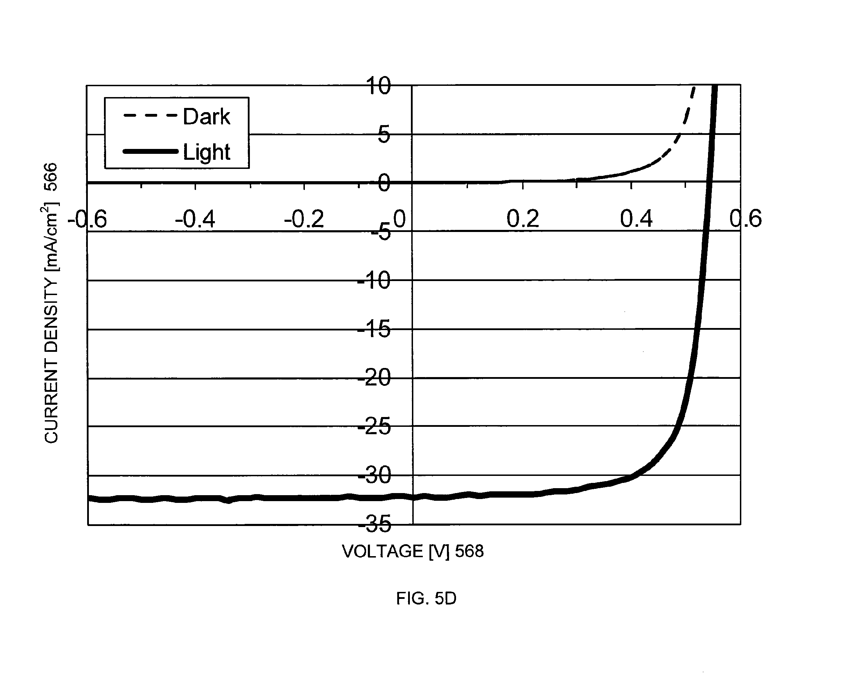

Referring now to FIG. 5D, a simplified diagram is shown of an experimental current-voltage (IV) plot for the p-type particle planar emitter 526 of FIG. 5B. This graph shows an IV curve under illumination from a simulated AM1.5G spectrum, generated using a 300W Oriel Solar Simulator; an IV curve measured in dark is also presented in this figure. The results, obtained with a non-optimized wafer configuration, are herein presented to show that substantial efficiency may be obtained using a particle homogeneous emitter. The inventors believe that the efficiency of a nanoparticle planar emitter solar cell may eventually reach or exceed that of a conventional solar cell.

In this example, 1" x 1" x 0.019" (2.54 cm x 2.54 cm x 0.048 cm) silicon wafer substrates doped with phosphorus to a resistivity of about 1 to 5 Ohm·cm were cleaned by treatment with NaOH, SC2, Buffered Oxide Etch (BOE), and Piranha, respectively.

In addition, a p-type silicon nanoparticle ink was prepared in an inert environment from silicon nanoparticles of about 10.0 nm +/- 0.5 nm as a 5 mg/ml solution of pyridine, which was sonicated using a sonication horn at 15% power for 15 minutes. Applying sufficient silicon nanoparticle ink to substantially cover the wafer surface, a silicon nanoparticle porous compact 526 was formed using spin casting, at 1000 rpm for 60 seconds. After baking this layer in an inert environment on a hotplate at 100°C for 30 minutes, a second silicon nanoparticle porous compact was formed using spin casting, at 1000 rpm for 60 seconds, followed by baking in an inert environment on a hotplate at 100°C for 30 minutes. The resulting thickness of the silicon nanoparticle porous compact layer was about 50 nm.

After the deposition and preconditioning steps were complete, the nanoparticle porous compact was processed at 1000°C for 20 seconds in a rapid-thermal-processing tool to neck the n+ particles together in order to form a contiguous semiconductor layer. After an $O_2$-plasma treatment at 100W for 60 seconds and Buffered Oxide Etch of 10 minutes, the contacts for current extraction were deposited on top of above described p+ particle planar emitters 526. The front electrode layer 504 was formed by deposition of a 230-nm-thick TCO layer (indium tin oxide (ITO)) directly on top of p+ planar emitter in order to improve conductivity. Outside of the 0.1 $cm^2$ area, defined by the TCO layer, the p+ planar emitter layer was removed by mesa etch using a $CF_4$ plasma in order to avoid parasitic current collection. The following results were obtained:

| | |
|---|---|
| $V_{OC}$ | 0.543V |
| $J_{SC}$ | 32.2 mA/cm² |
| FF | 0.726 |
| Efficiency | 12.7% |

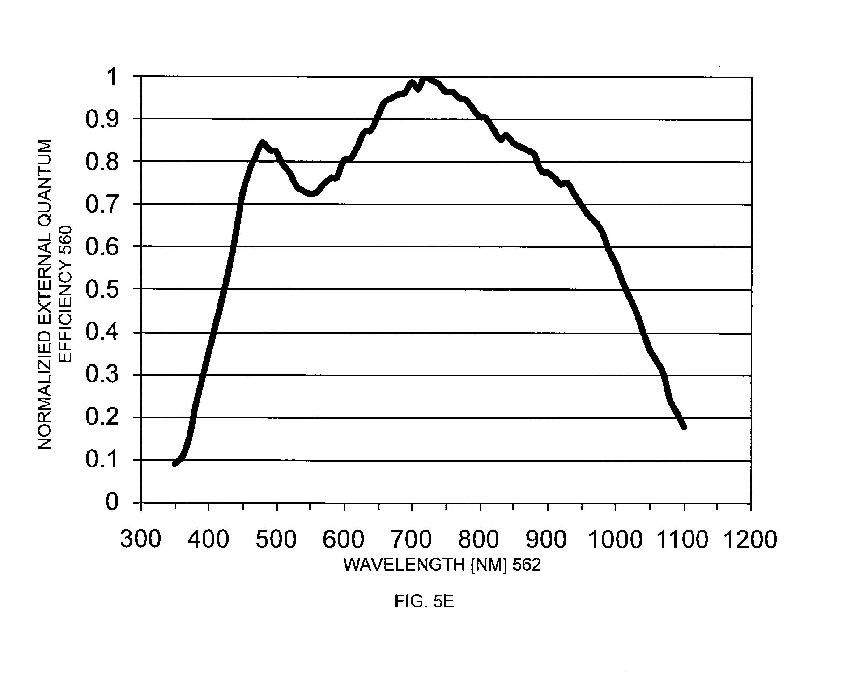

Referring to FIG. 5E, a simplified diagram of a normalized quantum efficiency (QE) plot is shown for the p-type particle planar emitter 526 of FIG. 5B.

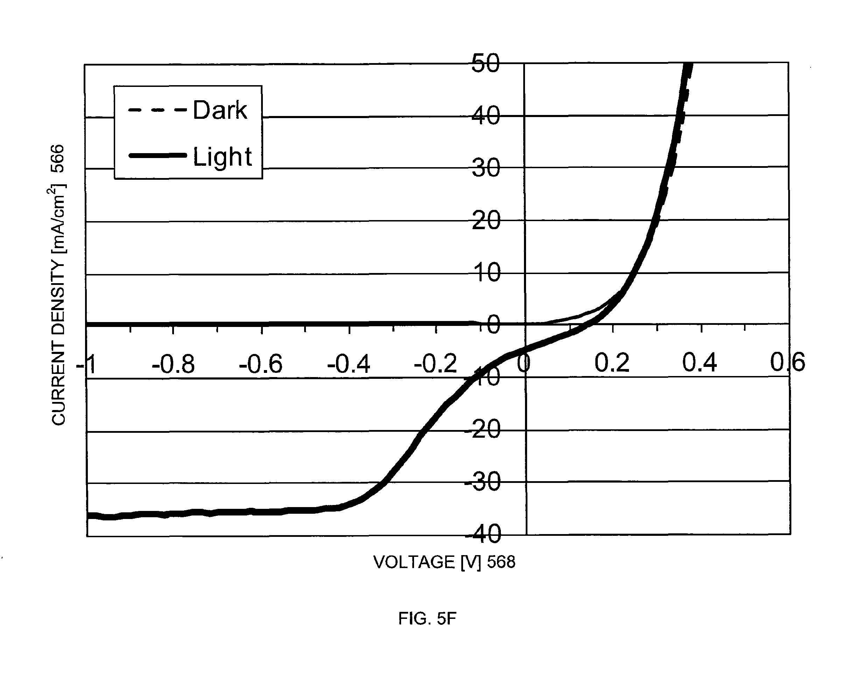

Referring to FIG. 5F, a simplified diagram of a set of IV curves for the silicon wafer substrates processed in the same way as in Example 2, with the ink-deposition step omitted. This configuration allows the contact for current extraction to be deposited directly on the n-type silicon substrate, thus providing a Schottky diode structure. For a given voltage 568, a current density 566 was measured in the dark and under AM1.5G illumination.

Such device structure results in very poor device performance, having a very low $V_{OC}$ of 0.12 V and an efficiency of about 0.1 % under simulated AM1.5G illumination. This comparison shows that a presence of a doped p+ emitter 526 in the described device structure is crucial for solar cell device operation for this device configuration.

## Example 3

As already described earlier in this section, the as-deposited particle porous compact can be treated by a variety of processes to fuse and density the film, thus rendering the film more mechanically robust and stable. This example describes using laser irradiation to achieve this.

In this example, 1" x 1" x 0.019" (2.54 cm x 2.54 cm x 0.048 cm) silicon wafer substrates doped with phosphorus to a resistivity of about 1 to 5 Ohm·cm were cleaned by treatment with NaOH, SC2, Buffered Oxide Etch (BOE), and Piranha, respectively.

In addition, a p-type silicon nanoparticles ink was prepared in an inert environment from silicon nanoparticles of about 10.0 nm +/- 0.5 nm as a 5 mg/ml solution of pyridine, which was sonicated using a sonication horn at 15% power for 15 minutes. Applying sufficient silicon nanoparticle ink to substantially cover the wafer surface, a silicon nanoparticle porous compact was formed using spin casting, at 1000 rpm for 60 seconds. After baking this layer in an inert environment on a hotplate at 100°C for 30 minutes, a second silicon nanoparticle porous compact was formed using spin casting, at 1000 rpm for 60 seconds, followed by baking in an inert environment on a hotplate at 100°C for 30 minutes. The resulting thickness of the silicon nanoparticle porous compact layer was about 65 to 80 nm.

After the printing and preconditioning steps were complete, the film was processed with a solid state Q-switched Nd:YAG laser with emission at 532 nm, having a 9 ns pulse duration and a repetition rate of 20 Hz, with a fluence of about 80 mJ/cm2, using 100 pulses. The 7 mm circular output beam of the laser was expanded and modified into a 1.1 cm x 1.1 cm square flat-top beam profile using a beam homogenizer. The processing was done in a vacuum atmosphere at a pressure of between about $9x10^{-6}$ and $5x10^{-5}$ torr (0.0012 Pa and 0.0067 Pa).

Compared to a control area on the same substrate, in which no laser processing was done, the laser processing resulted in a densified silicon thin film with substantially larger grain size than the porous compact. Fusion of the silicon thin film with the crystalline silicon substrate was evident from the scanning electron microscope (SEM) cross-section images. The thickness of the resulting silicon thin film was about 60-70nm.

In another particle homogeneous emitter configuration, a first layer of n-type silicon nanoparticles was printed onto a p-type silicon substrate in inert nitrogen atmosphere using inkjet printing. This first printed porous compact layer was heated at 200°C in nitrogen atmosphere for 5 minutes. Under these conditions, excess solvent was driven off, and the film was more mechanically robust. A second porous compact layer was printed and preconditioned as per the first layer.

The printed layers were then subjected to heating at 375°C under low pressure (4 torr (5.33 Pa)) nitrogen flow for about 20 minutes and cooling down in the same atmosphere for about 60 minutes. After the printing and preconditioning steps were complete, the particle homogeneous emitter 526 film of about 450 nm in thickness was processed with a solid state Q-switched Nd:YAG laser with emission at 532 nm, having a 6 ns pulse duration and a repetition rate of 20 Hz, with a fluence of about 50 mJ/cm$^2$, using 1000 pulses. The resulting thin film formed was about 270 nm in thickness and substantially densified as a result of laser processing in comparison to the porous compact untreated layer, which had substantially smaller grain size, as evident from SEM. The effect of laser irradiation on particle films has also been seen for undoped (intrinsic) particle layers.

## Example 4

Alternatively, as it was already mentioned above, a solar cell structure may be built using an n-doped printed emitter layer on a p-type wafer. One such example is described next.

In this example, 1" x 1" x 0.019" (2.54 cm x 2.54 cm x 0.048 cm) silicon wafer substrates doped with boron to a resistivity of about 1 to 5 Ohm·cm were cleaned by treatment with NaOH, SC2, Buffered Oxide Etch (BOE), and Piranha, respectively.

A silicon nanoparticle ink was prepared in an inert environment from n+ silicon nanoparticles of about 10.0 nm +/- 0.5 nm as a 20 mg/ml solution of tertbutanol:DEGDE (volume ratio 1:1), which was sonicated using a sonication horn at 15% power for 15 minutes. Applying sufficient silicon nanoparticle ink to substantially cover the wafer surface, a silicon nanoparticle porous compact was formed using inkjet printing with a dot spacing of 2000 dpi (dots per inch (2.54 cm)). Afterwards, this layer was baked in an inert environment on a hotplate at 200°C for 30 minutes, followed by an additional bake at 300°C for 5 minutes to remove excess solvent. After the deposition and preconditioning steps were complete, the nanoparticle porous compact was processed at 1000°C for 40 seconds in a rapid-thermal-processing tool to neck the n+ particles together in order to form a contiguous semiconductor layer 526. The front electrode layer 504 was formed by deposition of a 300-nm-thick TCO layer (ITO) directly on top of n+ planar emitter in order to improve conductivity. Outside of the 0.1 cm$^2$ area of the TCO layer, the n+ planar emitter layer was removed by mesa etch using a $CF_4$ plasma in order to avoid parasitic current collection, followed by an $O_2$-plasma treatment at 100W for 60 seconds. Before application of a layer of InGa eutectic to form the base contact 512, the back side of the sample was exposed to HF vapor for 30 seconds.

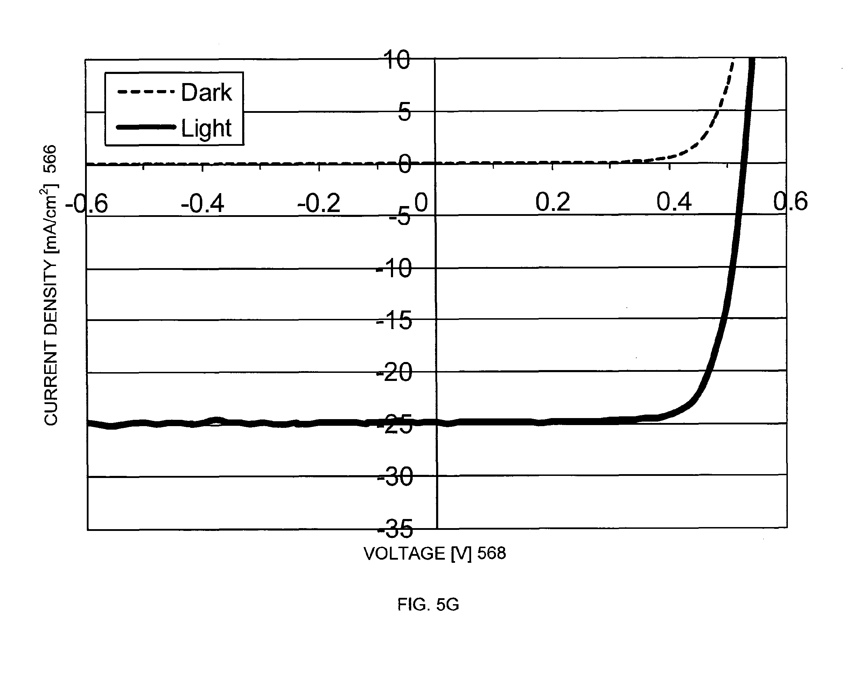

As can be seen from Figure 5G, the short-circuit current of such a device was 24.8 mA/cm$^2$, $V_{OC}$ was 527 mV, FF was 0.77 thus yielding an efficiency of 10.0 % under AM1.5G illumination.

## Example 5

Efficiency of printed emitter solar cells can be improved by varying a number of device parameters, one of which is the emitter thickness. By adjusting the thickness of the emitter layer 526 it is possible to adjust the amount of light absorbed in the particle homogenous emitter 526 layer thereby improving the efficiency of the solar cell. For example, the thickness can be controlled during inkjet printing by adjusting the concentration and/or chemical composition of the particle (nanoparticle) containing solution, or by variation of the dot-per-inch (DPI) ratio, or by variation of the number of printed layers, or by altering the parameters during the spin coating process, such as ramp rate and maximum spinning speed. Alternatively, particle homogenous emitter 526 may be first deposited and sintered, and then etched back using a chemical mixture (e.g., CP-4 (HF:HNO$_3$:IPA), NaOH, KOH or other well known silicon etchants) or with dry etching methods (e.g., $CF_4$ plasma etching, etc.).

In this example, 1" x 1" x 0.019" (2.54 cm x 2.54 cm x 0.048 cm) silicon wafer substrates doped with phosphorus to a resistivity of about 1 to 5 Ohm·cm were cleaned by treatment with NaOH, SC2, Buffered Oxide Etch (BOE), and Piranha, respectively.

In addition, a silicon nanoparticle ink was prepared in an inert environment from silicon nanoparticles of about 10.0 nm +/- 0.5 nm as a 20 mg/ml solution of chloroform:chlorobenzene (4:1 by volume), which was sonicated using a sonication horn at 15% power for 15 minutes. Applying sufficient silicon nanoparticle ink to substantially cover the wafer surface, a silicon nanoparticle porous compact was formed using spin casting, at 1000 rpm for 60 seconds, followed by baking in an inert environment on a hotplate at 100°C for 30 minutes. After the deposition and preconditioning steps were complete, the nanoparticle porous compact was processed at 1000°C for 20 seconds in a rapid-thermal-processing tool to neck the n+ particles together in order to form a contiguous semiconductor layer. The thickness of the sintered p+ particle planar emitter 526 was ~780 nm.

A sample that was processed in a similar way as described above was subjected to a 40 sec plasma dry etching process at 100 W plasma power and gas flow of 185 sccm CF4 and 20 sccm $O_2$ at a pressure of 515 mtorr. The thickness of the sintered p+ particle planar emitter 536 was reduced by the dry etching process to ~530 nm, as determined by cross-section SEM.

After an $O_2$-plasma treatment at 100W for 60 seconds and Buffered Oxide Etch of 10 minutes, the contacts for current extraction were deposited on top of above described p+ particle planar emitters 526. The front electrode layer 504 was formed by deposition of a 230 nm thick TCO layer (ITO) directly on top of p+ planar emitter in order to improve conductivity. Outside of the 0.1 $cm^2$ area of the TCO layer, the p+ planar emitter layer was removed by mesa etch using a $CF_4$ plasma in order to avoid parasitic current collection.

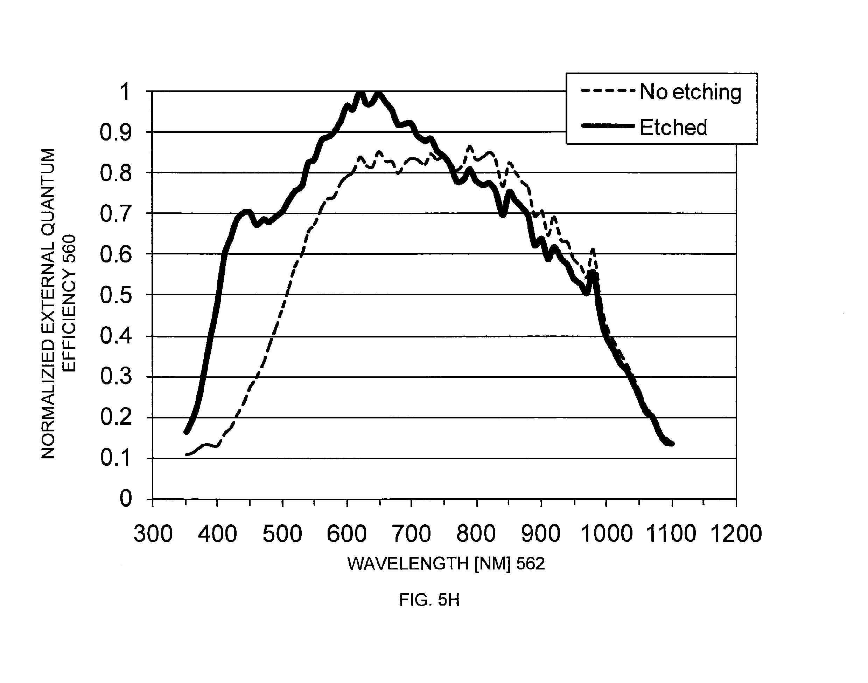

Referring now to FIG. 5H, a simplified quantum efficiency diagram is shown for the silicon wafer substrates of Example 5 above. For a given wavelength in nm 562, normalized quantum efficiency (QE) 560 was measured. For devices which underwent the above described dry etching process, the quantum efficiency for photons of wavelengths below 700 nm was significantly improved.

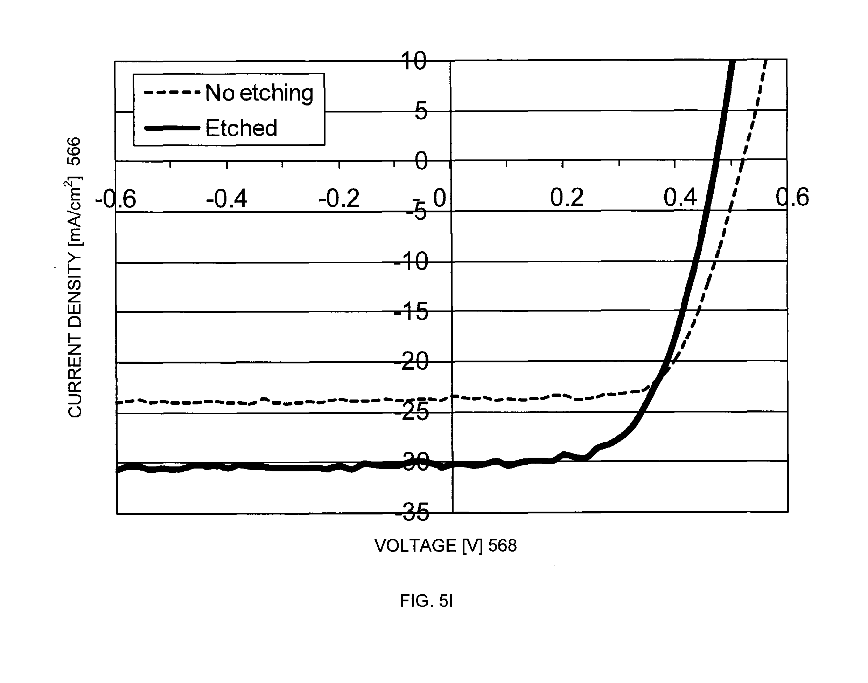

Referring now to FIG. 5I, a set of IV curves is shown for the silicon wafer substrates of Example 5 above. For a given voltage 568, a current density 566 was measured. The short circuit current density improved by at least 14 relative percent from at least 24.6 mA/$cm^2$ to at least 28.0 mA/$cm^2$ compared to devices with the original p+ particle planar emitter layer thickness, as shown in Figure 5I.

## Example 6

Another way to reduce the emitter thickness is to vary the ink deposition parameters, such as the spin-speed during the spin-coating process, as described in this example.

In this example, 1" x 1" x 0.019" (2.54 cm x 2.54 cm x 0.048 cm) silicon wafer substrates doped with phosphorus to a resistivity of about 1 to 5 Ohm·cm were cleaned by treatment with NaOH, SC2, Buffered Oxide Etch (BOE), and Piranha, respectively.

In addition, a silicon nanoparticle ink was prepared in an inert environment from silicon nanoparticles or about 10.0 nm +/- 0.5 nm as a 20 mg/ml solution of chloroform:chlorobenzene (4:1 by volume), which was sonicated using a sonication horn at 15% power for 15 minutes. Applying sufficient silicon nanoparticle ink to substantially cover the wafer surface, silicon nanoparticle porous compacts were formed using spin casting, at a spin-speed between 1000 rpm and 2900 rpm for 60 seconds, followed by baking in an inert environment on a hotplate at 100°C for 30 minutes. After the deposition and preconditioning steps were complete, the nanoparticle porous compacts were processed at 1000°C for 20 seconds in a rapid-thennal-processing tool to neck the n+ particles together in order to form a contiguous semiconductor layer, The thickness of the sintered p+ particle plantar emitters 526 varied, depending on the spin-speed used, between 190 and 400 nm, as revealed by cross-section SEM measurements,

After an $O_2$-plasma treatment at 100W for 60 seconds and Buffered Oxide Etch of 10 minutes, the contacts for current extraction were deposited on top of above described p+ particle planar emitters 526. The front electrode layer 504 was formed by deposition of a 230 nm thick TCO layer (ITO) directly on top of p+ planar emitter in order to improve conductivity. Outside of the 0.1 $cm^2$ area, defined by the TCO layer, the p+ planar emitter layer was removed by mesa etch using a $CF_4$ plasma in order to avoid parasitic current collection.

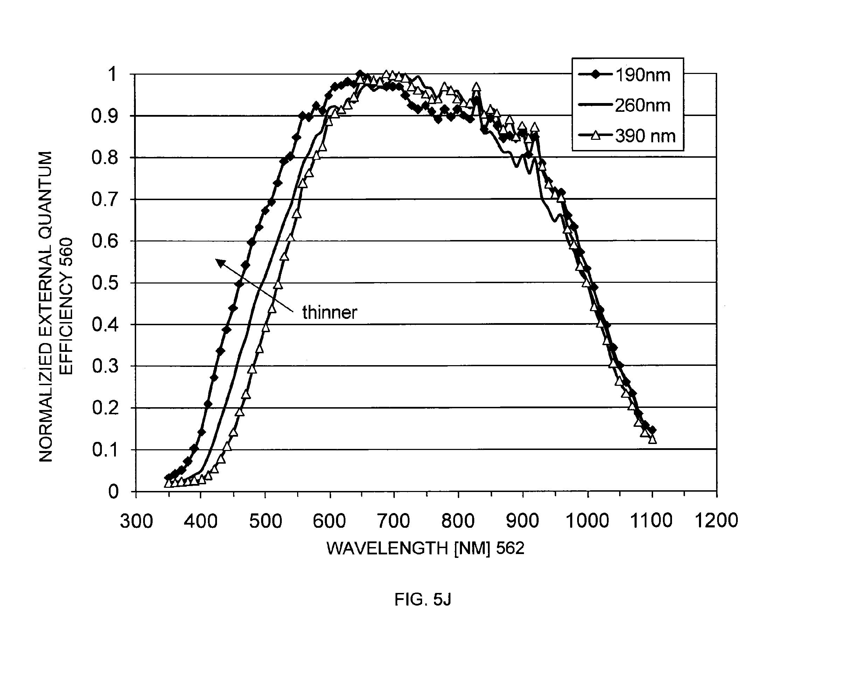

Referring now to FIG. 5J, a simplified diagram is shown with representative quantum efficiency results for the devices with various emitter thicknesses. For a given wavelength in nm 562, normalized quantum efficiency (QE) 560 was measured. In general, the response at wavelengths below 650 nm is enhanced by thinning down the emitter. For example, the photocurrent at a wavelength of 450 nm is enhanced three-fold when comparing emitter thickness of 390 nm to the emitter thickness of 190 nm. The observed enhancement of the spectral response is also accompanied by the corresponding increase of the short-circuit current, $J_{sc}$, as obtained from the current-voltage measurements.

## Example 7

Additionally, the dielectric layer 504 may also be configured as both an anti-reflective coating (e.g., $SiO_2$, $Si_xN_y$, $Ti_xO_y$, etc.) in order to minimize reflectivity (and thus allow more of the sunlight to enter the wafer), as well as a passivation layer (to both minimize external contamination, as well as substantially reduces charge traps caused by dangling Si bonds or imperfections in the wafer crystalline surface).

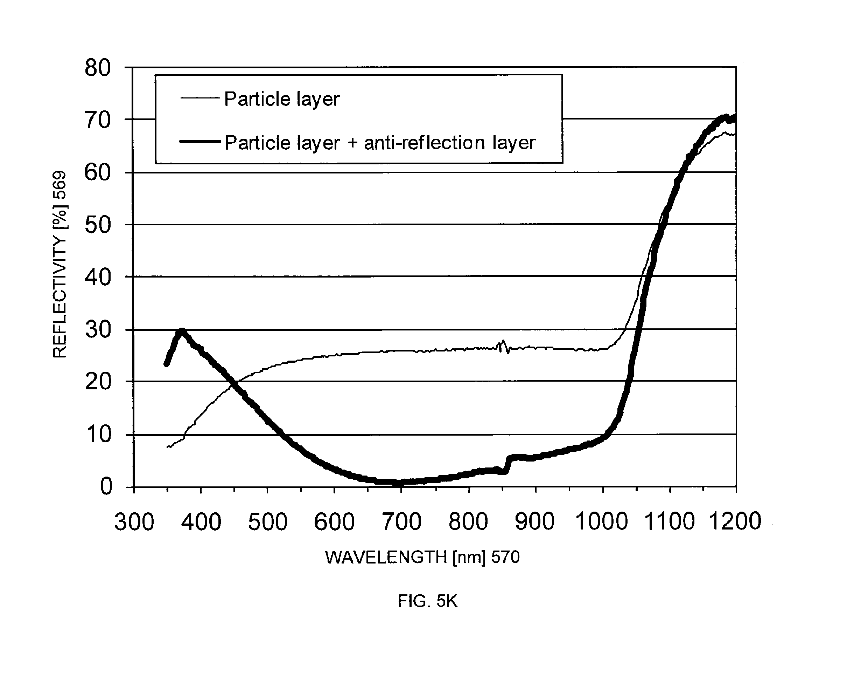

Referring now to FIG. 5K, a simplified diagram comparing the reflectivity of a p+ particle homogenous emitter wafer with the addition of an anti-reflective layer, to a p+ particle homogenous emitter wafer without an anti-reflective layer. A set of reflectivity measurements (reflectivity 569) was obtained recording reflectivity for different wavelengths of incident light (wavelength 570).

In Example 7, the reflectivity of p+ planar particle emitter layer was significantly reduced by PECVD deposition of a 73 nm silicon nitride layer on top of the planar particle emitter layer. As can be seen in FIG. 5K the reflectivity between 525 nm and 1000 nm was above 25 % for the p+ planar particle emitter layer, but between 0 % and 10 % for the sample with an additional silicon nitride anti-reflection layer.

## Example 8

Furthermore, emitter metal electrode 502 may be deposited, for example by screen printing, by inkjet printing (*e.g.*, by using solutions of metal nanoparticles), or by Physical Vapor Deposition (*e.g.*, thermal evaporation, e-beam deposition, sputtering, etc.), either directly on top of particle homogenous emitter 526, or on top of an additional TCO layer 504 (*e.g.,* indium tin oxide (ITO), etc.) in order to improve conductivity.

In the following, a set of planar particle emitter devices is described with metal grid contacts on the top. Two of the three configurations were fabricated using contact-less fabrication methods only, without inducing any stress to the wafer. In general, contact-less fabrication methods allow the use of very thin wafers while avoiding yield reduction due to wafer breakage during production, a common problem in conventional fabrication methods.

In this example, 1" x 1" x 0.019" (2.54 cm x 2.54 cm x 0.048 cm) silicon wafer substrates doped with phosphorus to a resistivity of about 1 to 5 Ohm·cm were cleaned by treatment with NaOH, SC2, Buffered Oxide Etch (BOE), and Piranha, respectively.

In addition, a silicon nanoparticle ink was prepared in an inert environment from p-type silicon nanoparticles of about 10.0 nm +/- 0.5 nm as a 20 mg/ml solution of chloroform:chlorobenzene (4:1 by volume), which was sonicated using a sonication horn at 15% power for 15 minutes. Applying sufficient silicon nanoparticle ink to substantially cover the wafer surface, a silicon nanoparticle porous compact was formed using spin casting, at 1000 rpm for 60 seconds, followed by baking in an inert environment on a hotplate at 100°C for 30 minutes. After the deposition and preconditioning steps were complete, the nanoparticle porous compact was processed at 1000°C for 20 seconds in a rapid-thermal-processing tool to neck the p+ particles together in order to form a contiguous semiconductor layer. After an $O_2$-plasma treatment at 100W for 60 seconds and Buffered Oxide Etch of 10 minutes, the contacts for current extraction were deposited. The front electrode layer 504 was formed by deposition of a 230 nm thick TCO layer (ITO) directly on top of p+ planar emitter in order to improve conductivity,

Outside of the cell area, defined by the TCO layer to be between 4 and 6 cm$^2$, the p+ planar emitter layer was removed by mesa etch using a $CF_4$ plasma in order to avoid parasitic current collection. Alternatively, the cell could be isolated by scanning the laser beam around the perimeter of the cell in order to remove TCO.

In one configuration, an emitter metal electrode 502 comprised of an 800 nm thick tapered bus bar of 1.7 mm width at the widest point and 18mm length, and 5 fingers of 300 um width, 18mm length, and 800 nm thickness was deposited by thermal evaporation of silver on top of the TCO layer at a pressure of 3x10$^{-6}$ mbar (3x10$^{-4}$ Pa). The base metal electrode 512 was a layer of InGa eutectic.

In another configuration, the preparation of wafer absorber 508, p+ planar emitter layer 526, and TCO layer 504 was the same as described above. However, the emitter metal electrode 502 comprised of a 500-800 nm thick bus bar of ~1.3 mm width and 18mm length, and 5 fingers of 300 um width, 18mm length, and 1000-1600 nm thickness was deposited by inkjet printing of silver nanoparticle solution at 25°C on top of the TCO layer, followed by drying on a hotplate at 200°C for 30 minutes to get rid of remaining solvents. The base metal electrode 512 was a layer of InGa eutectic.

In a third configuration, a conventional screen printing technique was used for the fabrication of the front grid on the devices with the p+ particle planar emitters. In this configuration, 1" x 1" x 0.019" (2.54 cm x 2.54 cm x 0.048 cm) silicon wafer substrates doped with phosphorus to a resistivity of about 1 to 5 Ohm·cm were cleaned by treatment with NaOH, SC2, Buffered Oxide Etch (BOE), and Piranha, respectively.

A p-type silicon nanoparticle ink was prepared in an inert environment from silicon nanoparticles of about 10.0 nm +/- 0.5 nm as a 5 mg/ml solution of pyridine, which was sonicated using a sonication horn at 15% power for 15 minutes. Applying sufficient silicon nanoparticle ink to substantially cover the wafer surface, a silicon nanoparticle porous compact was formed using spin casting, at 1000 rpm for 60 seconds. After baking this layer in an inert environment on a hotplate at 100°C for 30 minutes, a second silicon nanoparticle porous compact was formed using spin castling, at 1000 rpm for 60 seconds, followed by baking in an inert environment on a hotplate at 100°C for 30 minutes. The resulting thickness of the silicon nanoparticle porous compact layer 526 was about 50 nm.

After the deposition and preconditioning steps were complete, the nanoparticle porous compact 526 was processed at 1000°C for 20 seconds in a rapid-thermal-processing tool to neck the n+ particles together in order to form a contiguous semiconductor layer. After an $O_2$-plasma treatment at 100W for 60 seconds and Buffered Oxide Etch of 10 minutes, the front electrode layer 504 was formed by deposition of a 230 nm thick TCO layer (ITO) directly on top of p+ planar emitter in order to improve conductivity. Outside of the 5.4 cm² area of the TCO layer, the p+ planar emitter layer was removed by irradiation with a laser beam in order to avoid parasitic current shunting. A front metal grid 504 comprised of a 35 um thick bus bar of 1.5 mm width and 22 mm length, and 12 fingers of 350 um width, 20.5 mm length, and 35 um thickness was deposited by screen printing of silver paste on top of the TCO layer, followed by curing at 200°C for 20 minutes. The base metal electrode 512 was a layer of InGa eutectic.

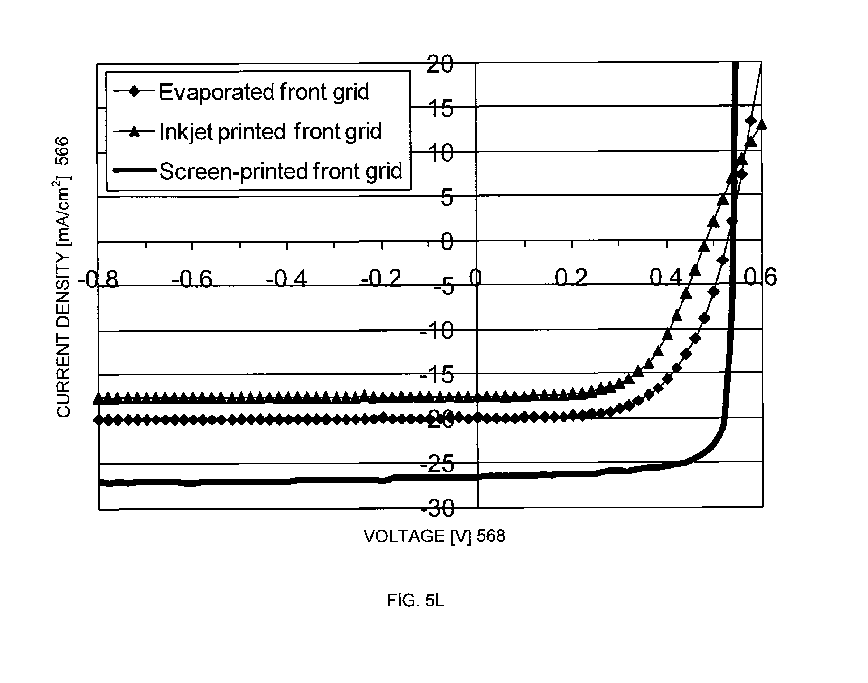

Referring now to FIG. 5L, a set of IV curves is shown for the three devices of Example 8 above under AM1.5G illumination. For a given voltage 568, a current density 566 was measured. The following values were obtained: For the devices with evaporated front grid, the short-circuit current was 19.3 mA/cm³, $V_{OC}$ was 536 mV, FF was 0.70 and efficiency was 7.2 %. For the devices with inkjet-printed front grid, the short-circuit current was 17.7 mA/cm², $V_{oc}$ was 499 mV, FF was 0.61 and efficiency was 5.4 %. Note that these results were achieved without optimizing certain device parameters.

For example, the thickness of the p+ planar emitter layer in the first two examples was ~780 nm, which is largely unoptimized for the value of Jsc. Higher short-circuit current values can be achieved using thinner emitter layers, as described earlier. The use of a front grid leads to losses caused by shadowing, the resistivity of the metal, and contact resistance, respectively. These losses can be reduced e.g., by increasing the metal thickness, which allows for a reduction of the dimensions of the front grid and a decrease of shadowing losses. The p+ particle planar emitter thickness of the device with screen-printed front grid was considerably lower, ~ 40-70 nm, and the thickness of the screen-printed grid was significantly higher, 35um, than the corresponding thicknesses in the first two examples, explaining higher device performance with a short-circuit current of 26.5 mA/cm², $V_{OC}$ of 541 mV, FF of 0.80 and an efficiency of 11.4 %.

## Example 9

In the following, the realization of even larger, 20 cm², area samples is described, using both p+ and n+ particle planar emitters, respectively.

In one configuration, 50mm x 50mm x 0.019" (0.048 cm) silicon wafer substrates doped with phosphorus to a resistivity of about 1 to 5 Ohm·cm were cleaned by treatment with NaOH, SC2, Buffered Oxide Etch (BOE), and Piranha, respectively. A silicon nanoparticle ink was prepared in an inert environment from p+ silicon nanoparticles of about 10.0 nm +/- 0.5 nm as a 20 mg/ml solution of chloroform:chlorobenzene (4:1 by volume), which was sonicated using a sonication horn at 15% power for 15 minutes. Applying sufficient silicon nanoparticle ink to substantially cover the wafer surface, a silicon nanoparticle porous compact was formed using spin casting, at 1000 rpm for 60 seconds, followed by baking in an inert environment on a hotplate at 100°C for 30 minutes. After the deposition and preconditioning steps were complete, the nanoparticle porous compact 526 was processed at 1000°C for 20 seconds in a rapid-thermal-processing tool to neck the p+ particles together in order to form a contiguous semiconductor layer.

After an $O_2$-plasma treatment at 100W for 60 seconds and Buffered Oxide Etch of 10 minutes, the contacts for current extraction were deposited. The front electrode layer 504 was formed by deposition of a 230 nm thick TCO layer (ITO) directly on top of p+ planar emitter 526 in order to improve conductivity. Outside of the 20 cm² area of the TCO layer, the p+ planar emitter layer was removed by mesa etch using a $CF_4$ plasma in order to avoid parasitic current collection. An emitter metal electrode 502 comprised of a 1000 nm thick tapered bus bar of 43 mm length and 6.8 mm width at the widest point, and 13 fingers of 43 mm length, and 250 um width and 1000 nm thickness was deposited by thermal evaporation of silver at a pressure of $3 \times 10^{-6}$ mbar ($3 \times 10^{-4}$ Pa). The base metal electrode 512 was a layer of InGa eutectic.

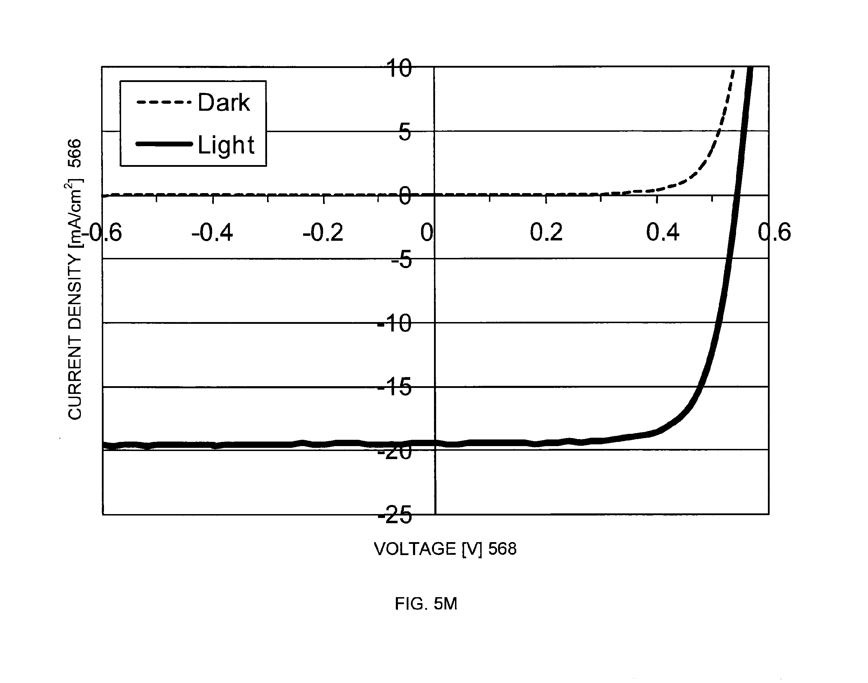

The short-circuit current of such a device was 19.4 mA/cm², $V_{OC}$ was 544 mV, FF was 0.73 and efficiency was 7.7 % (see Figure 5M).

In another configuration, a 50 mm x 50 mm x 0.019" (0.048 cm) silicon substrate doped with boron to a resistivity of about 1 to 5 Ohm·cm, and then cleaned by treatment with NaOH, SC2, Buffered Oxide Etch (BOE), and Piranha, respectively, was used, A silicon nanoparticle ink was prepared in an inert environment from n+ silicon nanoparticles of about 10.0 nm +/- 0.5 nm as a 40 mg/ml solution of cyclohexanol:cyclohexanone (1:1 by volume), which was sonicated using a sonication horn at 15% power for 15 minutes. Applying sufficient silicon nanoparticle ink to substantially cover the wafer surface, a silicon nanoparticle porous compact was formed using inkjet printing with a dot spacing of 2000 dpi (dots per inch (2.54 cm)). Afterwards, this layer was baked in an inert environment on a hotplate at 200°C for 30 minutes. After the deposition and reconditioning steps were complete, the nanoparticle porous compact 526 was processed at 1000°C for 20 seconds in a rapid-thermal-processing tool to neck the p+ particles together in order to form a contiguous semiconductor layer.

After an $O_2$-plasma treatment at 100W for 60 seconds and Buffered Oxide Etch of 10 minutes, the contacts for current extraction were deposited. The emitter metal electrode 504 was formed by deposition of a 230 nm thick TCO layer (ITO) directly on top of n+ planar emitter in order to improve conductivity. Outside of the 20 cm² area of the TCO layer, the n+ planar emitter layer was removed by mesa etch using a $CF_4$ plasma in order to avoid parasitic current collection. An emitter metal electrode 504 comprised of a 1000 nm thick tapered bus bar of 43 mm length and 6.8 mm width at the widest point

and 13 fingers of 250 um width and 1000 nm thickness was deposited by thermal evaporation of silver at a pressure of 3x10$^{-6}$ mbar (3x10$^{-4}$ Pa). The base metal electrode 512 was a layer of InGa eutectic. The short-circuit current of such a device was 25 mA/cm$^2$.

## B. Selective Emitter Solar Cell

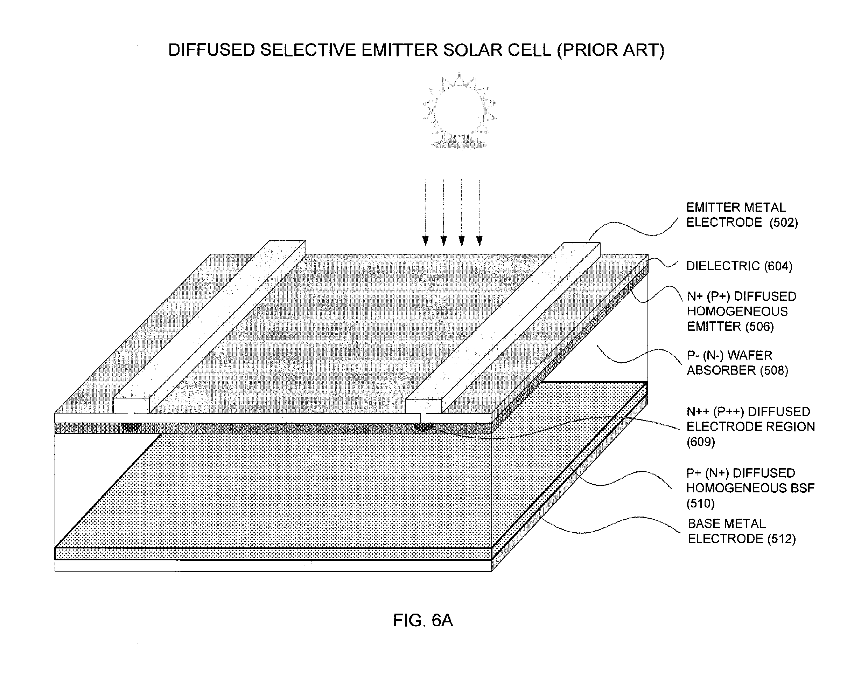

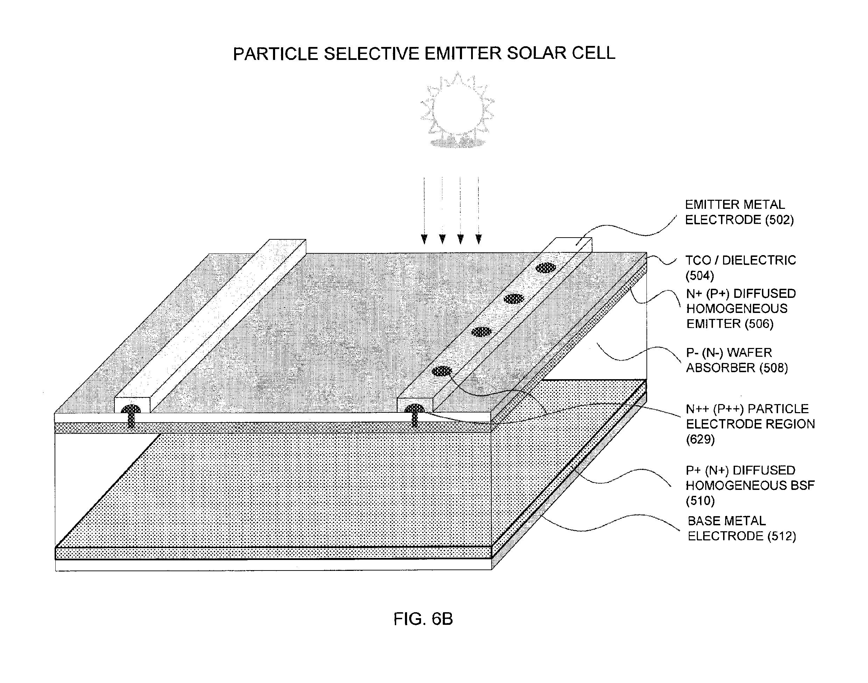

Referring now to FIGS. 6A-B, a set of simplified diagrams of selective emitter solar cells is shown. FIG. 6A shows a simplified diagram of a conventional diffused selective emitter solar cell. FIG. 6B shows a particle selective emitter solar cell. The selective emitter cell structure provides an efficiency increase over the homogeneous diffused emitter solar cells discussed above. See M. GREEN, SILICON SOLAR CELLS. ADVANCED PRINCIPLES AND PRACTICE Chap. 10 (Centre for Photovoltaic Devices and Systems, University of New South Wales, Sydney 1995).

In homogeneously diffused emitter solar cells a single dopant diffusion is generally used for both carrier collection and for contact with the emitter metal electrode 502 (as shown in FIG. 5A). The concentration of dopants within this diffusion is selected as a compromise between light doping for good carrier collection and heavy doping to form low resistance ohmic contacts. Due to this compromise the efficiency of such devices is typically limited by poor collection of shorter wavelength high energy photons that tend to be absorbed near the top of the solar cell in the homogeneous emitter

One solution is the use of multiple dopant concentrations, such as in the diffused selective emitter solar cell of FIG. 6A. That is, increasing the dopant concentration in localized regions very close to metal, such as diffused electrode region 609, and reducing the dopant concentrations in regions away from metal, such diffused homogenous emitter 506. However, as additional diffusion steps and masking are required, this potential increase in efficiency is offset by a corresponding increase in manufacturing costs.

## Example 10

Referring now to FIG. 6B, a particle selective emitter solar cell is shown. While not wishing to be bound by theory, it is believed by the inventors that substantially reducing the dopant concentration in diffused homogenous emitter 506, while substantially increasing the dopant concentration with particles in diffused electrode region 609, an efficient selective emitter solar cell may be created at about the same or lower cost as a conventional diffused selective emitter solar cell. The particles may be arranged in contiguous lines or isolated points depending on the desired device design.

In addition, unlike the diffused electrode region 609 of FIG. 6A, in which the diffused region is applied using costly, high-temperature or stress-inducing manufacturing methods, here in an advantageous manner, particle electrode region 629 may be directly deposited on wafer absorber 508 with simpler and cheaper deposition techniques, such as contactless with an inkjet printer, etc. In addition, the use of deposited nanoparticle inks allows for good deposition pattern control, reducing the need for costly masking and alignment steps.

In addition to modifying the collecting junction, a slightly modified selective emitter structure may be used to form a more optimal diffused homogenous BSF 510 and base metal electrode 512. In this case, a light diffusion (100-300 $\Omega/\square$) may be used to passivate the rear surface, and silicon ink is selectively deposited in regions to contact to the metal, using inkjet printing, etc.

In one configuration, particles are deposited in particle electrode region 629, prior to depositing TCO/dielectric 504, by contactless printing techniques, such as by inkjet printing.

An anti-reflective coating may then be deposited using CVD or other appropriate means. Emitter metal electrode 502 may then be applied via a silk-screening process, inkjet printing (*e.g.*, by using solutions of metal nanoparticles), or by Physical Vapor Deposition (*e.g.*, thermal evaporation, e-beam deposition, sputtering, etc.) as previously described. In general, an Ag paste with added glass frit is used and then subsequently heated in order to punch through the anti-reflective coating and to make contact with n+ particle electrode region 626, in order to create the junction. Silicon ink makes junction shunting less likely by locally increasing the depth of the emitter region at the locations where metal will try to punch through.

Alternatively, TCO/ dielectric 504 may be deposited first. A laser or other alternative technique may then be used to define channels in the TCO/ dielectric into which n+ particle ink is deposited and heated as described above. Consequently, the emitter metal electrode 502 may then be added to the exposed n+ particle channel.

Furthermore, as previously described, diffused BSF 510 may also be added on the wafer back-side in order to repel minority charge carriers and thus improve overall efficiency. In contact with diffused BSF 510 is generally base contact 512 (typically comprising a lower cost A1 paste) in order to extract the majority charge carriers (here holes). In addition, base contact 512 also serves as a mirror to reflect long wavelength light back into the cell for additional passes through the absorber.

## C. Point Junction Solar Cell

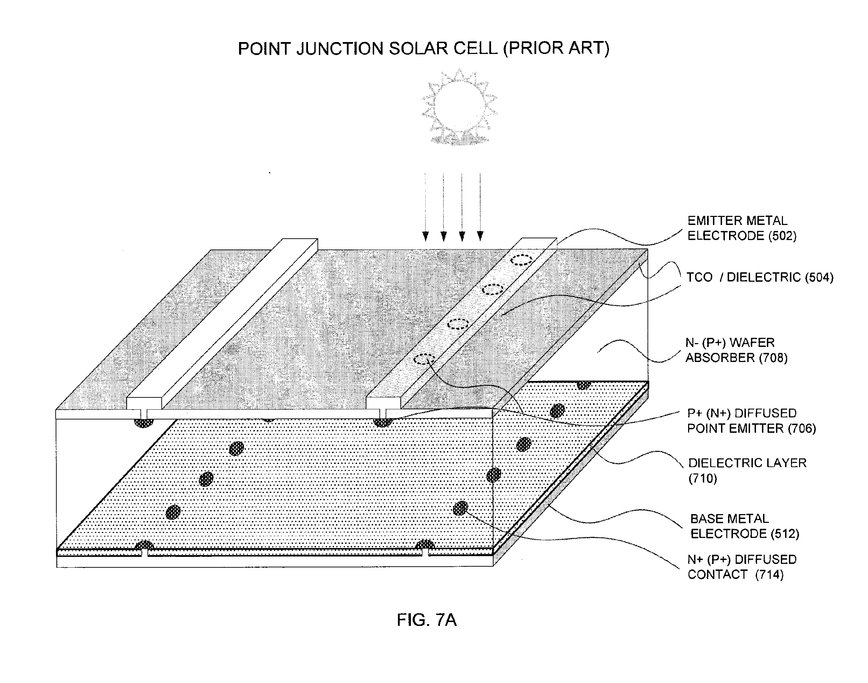

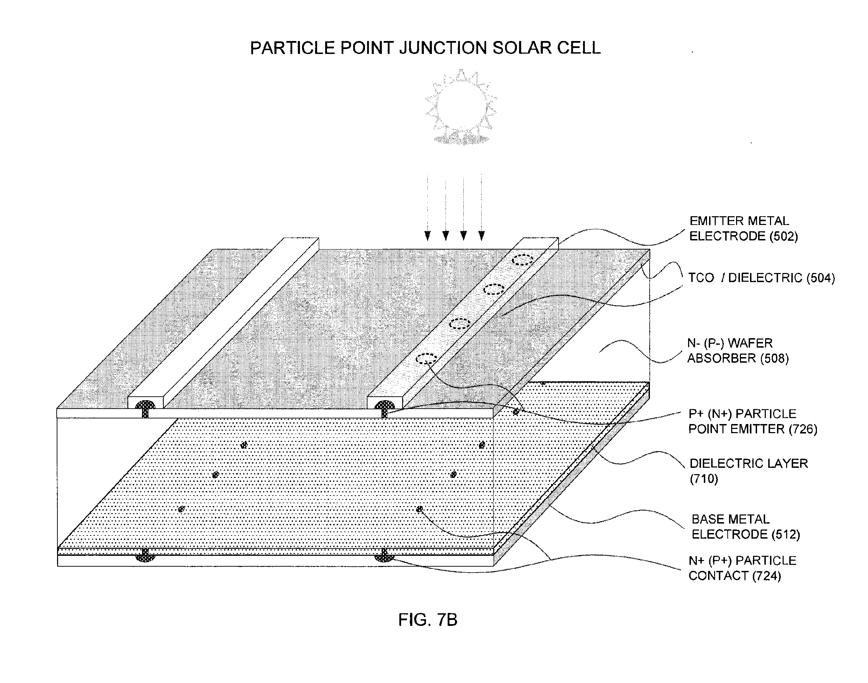

Referring now to FIGS. 7A-B, a set of simplified diagrams of point junction solar cells is shown. FIG. 7A shows a simplified diagram of a conventional diffused point junction solar cell. FIG. 7B shows a particle point junction solar cell.

Referring now to FIG. 7A, a simplified diagram of a conventional diffused point junction solar cell is shown. In general, an alternate approach to achieving high efficiency in solar cells is to reduce the area of the collection junction from a relatively large area diffused homogenous emitter to a to a series of diffused point emitters 706 (alternatively, other reduced configurations may also be used, such as lines, etc.). Consequently, the treatment of the remaining surfaces can be optimized to reduce the recombination, thus improving efficiency. See R. R. King, R. A. Sinton, R. M. Swanson, Studies of diffused phosphorus emitters: saturation current, surface recombination velocity and quantum effciency, 37 no. 2, IEEE TRANS. ELEC. DEV. (1990). In addition, the interfaces to base metal electrode 512 may also be reduced by the addition of dielectric layer 710 with a series of reduced area diffused contacts 714.

While the performance of these devices is generally high, the manufacturing of reduced area collection junctions is generally difficult due to the use of costly traditional semiconductor processing techniques, such as photolithography, in order to define the different regions.

Referring now to FIG. 7B, a particle point junction solar cell is shown. While not wishing to be bound by theory, it is believed by the inventors that replacing the set of reduced area diffused emitters in FIG. 7A (diffused point emitter 706) with a set of reduced area fused particle emitters (particle point emitter 726), and also optionally replacing the set of reduced area diffused contacts (diffused contract 714) with a set of reduced area fused particle contacts (particle contact 724), an efficient solar cell may be created at about the same or lower cost as a conventional reduced area emitter solar cell.

## D. All Back-Side Electrode Point Contact Solar Cell

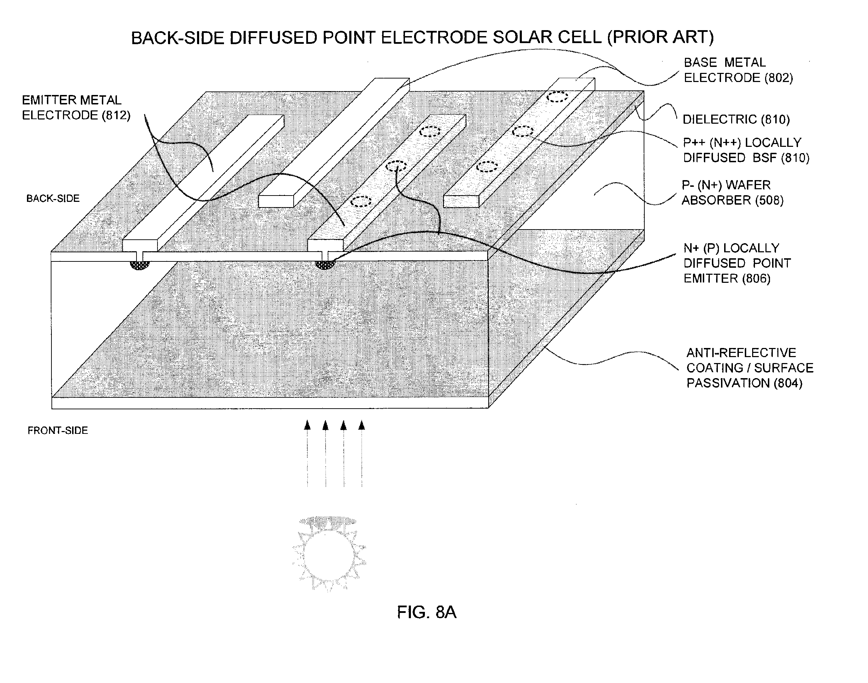

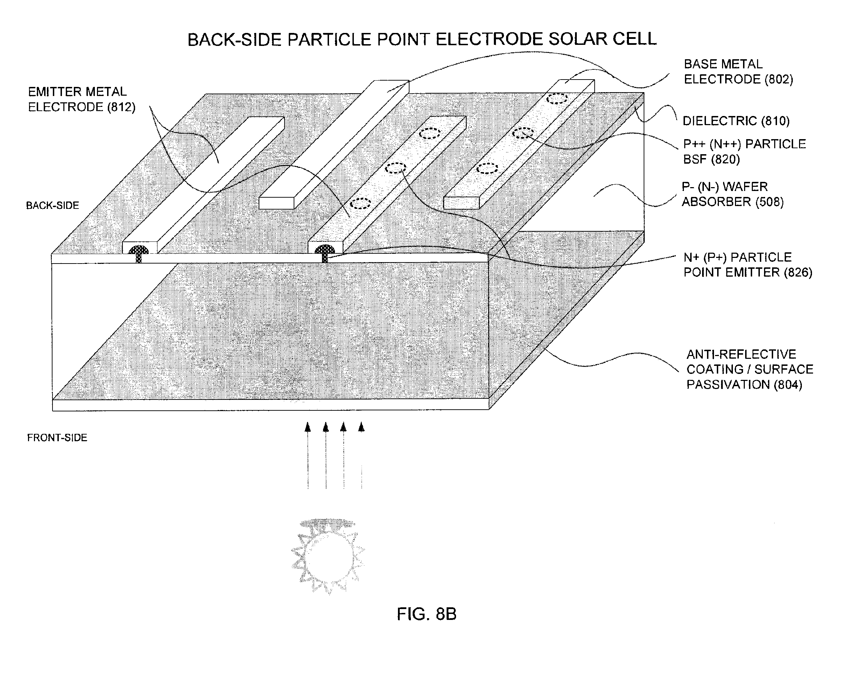

Referring now to FIGS. 8A-B, a set of simplified diagrams of an all back-side electrode point contact solar cells is shown, which is not part of the present invention. FIG. 8A shows a simplified diagram of a conventional diffused point contact solar cell. FIG. 8B shows a simplified diagram of a back-side electrode particle point contact solar cell.

Referring now to FIG. 8A, a simplified diagram is shown of a conventional diffused point contact solar cell. In general, one solution to increasing the efficiency of conventional solar cells has been to place all the contacts on the back-side in an interdigitated manner. That is, interweaving alternating n-type regions and p-type regions. Increased currents are achieved by eliminating the shading losses usually incurred from the metal on the front side. Additionally, these solar cell structures are easier to interconnect into modules.

However, all back-contact structures are generally harder to fabricate since they require several aligned masking steps to define the rear diffused regions and electrodes. The inventors believe that the use of silicon nanoparticle ink greatly reduces the complexity of manufacturing such structures.

Referring now to FIG. 8B, a simplified diagram of a back-side electrode particle point contact solar cell is shown. Unlike the diffused point contact solar cell of FIG. 8A, the doped regions of the cell structure described herein may be created with fewer processing steps. In one method of deposition, prior to the deposition of dielectric layer 810, lines of n+ particles and p+ particles may be deposited using an appropriate deposition technique, such as an inkjet printer. Dielectric layer 810 may then be deposited using appropriate means, such as PECVD. Emitter metal electrode 812 and base metal electrode 802 may then be applied via a silk-screening process, inkjet printing (e.g., by using solutions of metal micro- or nano-particles), or by Physical Vapor Deposition (*e.g.*, thermal evaporation, e-beam deposition, sputtering, etc.) as previously described. In general, an Ag paste with glass frit is applied and then heated in order to punch through the dielectric 810 and to make contact with fused particle BSF 820 and particle point emitter 826.

Alternatively, dielectric layer 810 may be deposited first. A laser or other alternative technique may then be used to define channels into which particles may be deposited and heated as described above. Consequently, the metal may then be added to the exposed particle channels.

For the purposes of this disclosure and unless otherwise specified, "a" or "an" means "one or more." All patents, applications, references and publications cited herein are incorporated by reference in their entirety to the same extent as if they were individually incorporated by reference.

The invention has been described with reference to various specific and illustrative embodiments. However, it should be understood that many variations and modifications may be made while remaining within the spirit and scope of the invention. Advantages of the invention include the production of low cost and efficient junctions for electrical devices, such as solar cells.

Having disclosed exemplary embodiments and the best mode, modifications and variations may be made to the disclosed embodiments while remaining within the subject and spirit of the invention as defined by the following claims.

## Claims

1. A device for generating electricity from solar radiation, comprising:

    a wafer doped with a first dopant, the wafer including a front-side and a back-side, wherein the front-side is configured to be exposed to the solar radiation, the wafer further including a front-side diffused region, wherein the front-side diffused region is doped with a second dopant, the second dopant being a counter dopant to the first dopant;
    a sintered Group IV nanoparticle back surface field (BSF) layer deposited on the back-side;
an electrode deposited on the back-side, wherein said electrode is in electrical contact with the fused Group IV nanoparticle BSF layer;
wherein when the solar radiation is applied to the front-side, an electrical current is produced.

## Patentansprüche

1. Vorrichtung zum Erzeugen von Elektrizität aus Solarstrahlung, umfassend:

einen Wafer, der mit einem ersten Dotiermittel dotiert ist, wobei der Wafer eine Vorderseite und eine Rückseite umfasst, wobei die Vorderseite konfiguriert ist, der Solarstrahlung ausgesetzt zu werden, wobei der Wafer ferner eine vorderseitige diffundierte Region umfasst, wobei die vorderseitige diffundierte Region mit einem zweiten Dotiermittel dotiert ist, wobei das zweite Dotiermittel ein Gegendotiermittel zum ersten Dotiermittel ist;
eine auf der Rückseite abgesetzte Schicht eines hinteren Oberflächenfelds (HOF) aus gesinterten Nanopartikeln der Gruppe IV;
eine auf der Rückseite abgesetzte Elektrode, wobei die Elektrode in elektrischem Kontakt mit der HOF-Schicht aus geschmolzenen Nanopartikeln der Gruppe IV steht;
wobei, wenn die Solarstrahlung auf die Vorderseite aufgebracht wird, ein elektrischer Strom erzeugt wird.

## Revendications

1. Dispositif de génération d'électricité à partir du rayonnement solaire, comprenant:

une galette dopée avec un premier dopant, la galette comprenant une face avant et une face arrière, où la face avant est configurée pour être exposée au rayonnement solaire, la galette comprenant en outre une région de diffusion en face avant, où la région de diffusion en face avant est dopée à l'aide d'un second dopant, le second dopant étant un contre-dopant par rapport au premier dopant;
une couche de champ répulsif face arrière (BSF) de nanoparticules du Groupe IV frittée déposée sur la face arrière;
une électrode déposée sur la face arrière, où ladite électrode se trouve en contact électrique avec la couche BSF de nanoparticules du Groupe IV fondues;
où lorsque le rayonnement solaire est appliqué à la face avant, un courant électrique est produit.

FIG. 1

FIG. 2

FIG. 3

EP 2 191 513 B1

FIG. 4A

EP 2 191 513 B1

FIG. 4B

FIG. 4C

DIFFUSED HOMOGENEOUS EMITTER SOLAR CELL (PRIOR ART)

EMITTER METAL ELECTRODE (502)

TCO / DIELECTRIC (504)

N+ (P+) DIFFUSED HOMOGENEOUS EMITTER (506)

P- (N-) WAFER ABSORBER (508)

P+ (N+) HOMOGENEOUS DIFFUSED BSF (510)

BASE METAL ELECTRODE (512)

FIG. 5A

EP 2 191 513 B1

PARTICLE HOMOGENEOUS EMITTER SOLAR CELL

EMITTER METAL
ELECTRODE (502)

TCO / DIELECTRIC (504)

N+ (P+) PARTICLE
HOMOGENEOUS
EMITTER (526)

UPPER INTRINSIC
PARTICLE BUFFER
[OPTIONAL] (527)

P- (N-) WAFER
ABSORBER (508)

P+ (N+) PARTICLE BSF
(520)

LOWER INTRINSIC
PARTICLE BUFFER
[OPTIONAL] (511)

BASE METAL
ELECTRODE (512)

FIG. 5B

FIG. 5C

FIG. 5D

EP 2 191 513 B1

FIG. 5E

FIG. 5F

FIG. 5G

EP 2 191 513 B1

FIG. 5H

FIG. 5I

VOLTAGE [V] 568

CURRENT DENSITY [mA/cm²] 566

No etching

Etched

FIG. 5J

FIG. 5K

FIG. 5L

EP 2 191 513 B1

FIG. 5M

DIFFUSED SELECTIVE EMITTER SOLAR CELL (PRIOR ART)

EMITTER METAL
ELECTRODE (502)

DIELECTRIC (604)

N+ (P+) DIFFUSED
HOMOGENEOUS
EMITTER (506)

P- (N-) WAFER
ABSORBER (508)

N++ (P++) DIFFUSED
ELECTRODE REGION
(609)

P+ (N+) DIFFUSED
HOMOGENEOUS BSF
(510)

BASE METAL
ELECTRODE (512)

FIG. 6A

EP 2 191 513 B1

PARTICLE SELECTIVE EMITTER SOLAR CELL

EMITTER METAL ELECTRODE (502)

TCO / DIELECTRIC (504)

N+ (P+) DIFFUSED HOMOGENEOUS EMITTER (506)

P- (N-) WAFER ABSORBER (508)

N++ (P++) PARTICLE ELECTRODE REGION (629)

P+ (N+) DIFFUSED HOMOGENEOUS BSF (510)

BASE METAL ELECTRODE (512)

FIG. 6B

EP 2 191 513 B1

POINT JUNCTION SOLAR CELL (PRIOR ART)

EMITTER METAL
ELECTRODE (502)

TCO / DIELECTRIC (504)

N- (P+) WAFER
ABSORBER (708)

P+ (N+) DIFFUSED
POINT EMITTER (706)

DIELECTRIC LAYER
(710)

BASE METAL
ELECTRODE (512)

N+ (P+) DIFFUSED
CONTACT (714)

FIG. 7A

EP 2 191 513 B1

PARTICLE POINT JUNCTION SOLAR CELL

EMITTER METAL
ELECTRODE (502)

TCO / DIELECTRIC (504)

N- (P-) WAFER
ABSORBER (508)

P+ (N+) PARTICLE
POINT EMITTER (726)

DIELECTRIC LAYER
(710)

BASE METAL
ELECTRODE (512)

N+ (P+) PARTICLE
CONTACT (724)

FIG. 7B

EP 2 191 513 B1

BACK-SIDE DIFFUSED POINT ELECTRODE SOLAR CELL (PRIOR ART)

BASE METAL
ELECTRODE (802)

EMITTER METAL
ELECTRODE (812)

DIELECTRIC (810)

P++ (N++) LOCALLY
DIFFUSED BSF (810)

BACK-SIDE

P- (N+) WAFER
ABSORBER (508)

N+ (P) LOCALLY
DIFFUSED POINT
EMITTER (806)

ANTI-REFLECTIVE
COATING / SURFACE
PASSIVATION (804)

FRONT-SIDE

FIG. 8A

EP 2 191 513 B1

BACK-SIDE PARTICLE POINT ELECTRODE SOLAR CELL

EMITTER METAL
ELECTRODE (812)

BASE METAL
ELECTRODE (802)

DIELECTRIC (810)

P++ (N++) PARTICLE
BSF (820)

P- (N-) WAFER
ABSORBER (508)

BACK-SIDE

N+ (P+) PARTICLE
POINT EMITTER (826)

ANTI-REFLECTIVE
COATING / SURFACE
PASSIVATION (804)

FRONT-SIDE

FIG. 8B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 02983808 A
- US 96988707 P

- US 87487306 P

**Non-patent literature cited in the description**

- Studies of diffused phosphorus emitters: saturation current, surface recombination velocity and quantum effciency. **R. R. KING ; R. A. SINTON ; R. M. SWANSON.** IEEE TRANS. ELEC. DEV. 1990, vol. 37